# EUROPEAN PATENT APPLICATION

(11) **EP 4 564 428 A1**
(43) Date of publication of application: **04.06.2025**
(21) Application number: 23868348.6
(22) Date of filing: 20.07.2023
(51) Int. Cl.: H01L 25/075, H01L 33/62, H01L 27/15, G09F 9/302, H01L 33/48, H01L 33/52, H01L 33/44

(54) **DISPLAY APPARTUS HAVING DISPLAY MODULE AND MANUFACTURING METHOD THEREOF**

(30) Priority: 19.09.2022 KR 20220118210; 04.11.2022 KR 20220146520
(71) Applicant: Samsung Electronics Co., Ltd., Suwon-si, Gyeonggi-do 16677 (KR)
(72) Inventor: SHIN, Seonghwan, Suwon-si Gyeonggi-do 16677 (KR); BAE, Kyounghwan, Suwon-si Gyeonggi-do 16677 (KR); HONG, Soonmin, Suwon-si Gyeonggi-do 16677 (KR); KIM, Gunwoo, Suwon-si Gyeonggi-do 16677 (KR)
(74) Representative: Gulde & Partner
(86) International application number: PCT/KR2023/010486
(87) International publication number: WO 2024/063288

(57) **Abstract**

According to one embodiment of the present disclosure, a display module comprises: a substrate including a mounting surface on which a thin film transistor (TFT) layer is formed, a side surface, and a rear surface disposed on the opposite side of the mounting surface; a plurality of inorganic light-emitting elements mounted on the mounting surface; an anisotropic conductive layer electrically connecting the TFT layer and the plurality of inorganic light-emitting elements, and disposed on the upper surface of the TFT layer; a front cover covering the front surface of the anisotropic conductive layer; a side cover surrounding the side surface of the anisotropic conductive layer; and a side end member sealing the outer end of the side cover. The side end of the front cover extends to an area outside the mounting surface, the side end of the anisotropic conductive layer extends to the area outside the mounting surface so as to be disposed at a position corresponding to the side end of the front cover, the side cover is provided to contact the lower surface of the anisotropic conductive layer corresponding to the area outside the mounting surface, and the side end member is configured to seal an adhesive portion of the side end of the front cover and the side end of the anisotropic conductive layer.

## Description

### [Technical Field]

The present disclosure relates to a display apparatus configured to display an image by combining modules including self-luminous inorganic light-emitting devices mounted on a substrate.

### [Background Art]

A display apparatus is a type of output device visually displaying data information such as text and figures, and images.

In general, as a display apparatus, a liquid crystal panel (LCD) that requires a backlight or an organic light-emitting diode (OLED) panel that is formed of a film of a self-emitting organic compound in response to a current have been generally used. However, the LCD has problems of slow response time, high power consumption, and difficulty in manufacturing to a compact size due to non-self-emitting property and necessity of a backlight. In addition, because the OLED panel has self-emitting property, a backlight is not required and thickness may be reduced, but the OLED is vulnerable to the burn-in (deterioration) phenomenon in which a certain part of a previous screen remains even after the screen is changed due to expired lifespan of sub pixels in the case where the same screen is displayed for a long time. Therefore, as a new panel replacing those described above, micro-light-emitting diode (micro-LED or µLED) panels, in which inorganic light-emitting devices are mounted on a substrate and the inorganic light-emitting devices are used as pixels, have been studied.

A micro-LED display panel (hereinafter, referred to as micro-LED panel) is one of flat display panels and includes a plurality of inorganic LEDs, each has a size of 100 µm or less.

Although such LED panels are self-emitting devices, the burn-in phenomenon does not occur because they are inorganic light-emitting devices, and excellent brightness, resolution, power consumption, and durability may be obtained.

Micro-LED panels provide better contrast, response time, and energy efficiency than LCD panels that requires a backlight. While both an organic LED and a micro-LED panel that is an inorganic LED have higher energy efficiency, the micro-LED is brighter, has a higher luminous efficiency, and has a longer lifespan.

In addition, by arranging LEDs on a circuit board in pixel units, display modules in substrate units may be manufactured, it is easy to manufacture display apparatuses in various resolutions and screen sizes in accordance with customers order.

### [Disclosure]

### [Technical Problem]

Embodiments of the disclosure provide a display apparatus and a manufacturing method thereof, and technical features for protecting display modules against infiltration of an external solution thereinto in the display modules suitable for a large screen and a display apparatus including the same.

Embodiments of the disclosure also provide technical features for protecting display modules against static electricity in the display modules and a display apparatus including the same.

However, the technical problems to be solved by the present disclosure are not limited to the aforementioned problems, and any other technical problems not mentioned herein will be clearly understood from the following description by those skilled in the art to which the present disclosure pertains.

### [Technical Solution]

According to an example embodiment of the present disclosure, a display module includes a substrate including a mounting surface on which a thin film transistor (TFT) layer is formed, a side surface, and a rear surface disposed on the opposite side of the mounting surface, a plurality of inorganic light-emitting devices mounted on the mounting surface, an anisotropic conductive layer electrically connecting the TFT layer with the plurality of inorganic light-emitting devices and disposed on the upper surface of the TFT layer, a front cover covering a front surface of the anisotropic conductive layer, a side cover surrounding a side surface, and a side end member sealing an outer end of the side cover.

A side end of the front cover extends to an area outside the mounting surface.

A side end of the anisotropic conductive layer extends to the area outside the mounting surface to be disposed at a position corresponding to the side end of the front cover.

The side cover is in contact with the lower surface of the anisotropic conductive layer corresponding to the area outside the mounting surface.

The side end member is configured to seal an adhesive portion of the side end of the front cover and the side end of the anisotropic conductive layer.

The front end of the side end member is disposed at a position corresponding to the front end of the front cover in a direction where the mounting surface faces.

The display module further includes a metal plate bonded to the rear surface.

The side end member extends to at least a portion of the side surface of the metal plate from a position corresponding to the front end of the front cover.

The side cover extends from the lower surface of the anisotropic conductive layer corresponding to the area outside the mounting surface to at least a portion of the side surface of the metal plate.

The side end member comprises a moisture-proof material preventing and/or reducing infiltration of moisture.

The side end member comprises a water repellent material.

The side end member has a black-toned color.

The side cover has a black-toned color.

The side end member comprises a moisture-proof material preventing and/or reducing infiltration of moisture.

The side cover comprises a water repellent material.

The side end member is configured to seal an adhesive portion of the front cover and the anisotropic conductive layer, an adhesive portion of the anisotropic conductive layer and the side cover, and an adhesive portion of the metal plate and the side cover.

According to an example embodiment of the present disclosure, a display apparatus includes: an array of a plurality of display modules comprising displays horizontally arranged in a M*N matrix, and a frame supporting the plurality of display modules, wherein each of the plurality of display modules includes a substrate including a mounting surface on which a thin film transistor (TFT) layer is formed, a side surface, and a rear surface disposed on the opposite side of the mounting surface, a plurality of inorganic light-emitting devices mounted on the mounting surface, an anisotropic conductive layer electrically connecting the TFT layer with the plurality of inorganic light-emitting devices and disposed on the upper surface of the TFT layer, a front cover covering the front surface of the anisotropic conductive layer, a side cover surrounding the side surface, and a side end member configured to seal the outer end of the side cover.

A side end of the front cover extends to an area outside the mounting surface.

A side end of the anisotropic conductive layer extends to an area outside the mounting surface to be disposed at a position corresponding to the side end of the front cover.

The side cover is in contact with the lower surface of the anisotropic conductive layer corresponding to the area outside the mounting surface.

The side end member is configured to seal an adhesive portion of the side end of the front cover and the side end of the anisotropic conductive layer.

The front end of the side end member is disposed at a position corresponding to the front end of the front cover in a direction where the mounting surface faces.

The display apparatus further includes a metal plate bonded to the rear surface.

The side end member extends to at least a portion of the side surface of the metal plate from a position corresponding to the front end of the front cover.

The side cover extends from the lower surface of the anisotropic conductive layer corresponding to the area outside the mounting surface to at least a portion of the side surface of the metal plate

The side end member comprises a moisture-proof material preventing and/or reducing infiltration of moisture .

The side end member has a black-toned color.

The side end member may be configured to seal an adhesive portion of the front cover and the anisotropic conductive layer, an adhesive portion of the anisotropic conductive layer and the side cover, and an adhesive portion of the metal plate and the side cover.

According to an example embodiment of the present disclosure, a display module includes a substrate including a mounting surface on which a thin film transistor (TFT) layer is formed, a side surface, and a rear surface disposed on the opposite side of the mounting surface, a plurality of inorganic light-emitting devices mounted on the mounting surface, an anisotropic conductive layer electrically connecting the TFT layer with the plurality of inorganic light-emitting devices and disposed on the upper surface of the TFT layer, a metal plate bonded to the rear surface, a front cover covering the front surface of the anisotropic conductive layer, a side cover surrounding the side surface of the substrate and extending from the lower surface of the anisotropic conductive layer to at least a portion of the side surface of the metal plate, and a side end member disposed at the outer end of the side cover.

The side end member may be configured to seal an adhesive portion of the front cover and the anisotropic conductive layer, an adhesive portion of the anisotropic conductive layer and the side cover, and an adhesive portion of the metal plate and the side cover.

The side end member may extend to at least a portion of the side surface of the metal plate from a position corresponding to the front end of the front cover.

The display apparatus according to an example embodiment of the present disclosure may have improved reliability against infiltration of an external solution because the display module is sealed by the front cover in the vertical direction and the side surface in the lateral direction.

The display apparatus according to an example embodiment of the present disclosure may have an increased electrostatic discharge (ESD) protection towithstand voltage against electrostatic discharge that may occur in display modules because the side end of the anisotropic conductive layer is covered in each of the display modules.

However, the effects obtainable by the present disclosure are not limited to the aforementioned effects, and any other effects not mentioned herein will be clearly understood from the following description by those skilled in the art to which the present disclosure pertains.

### [Description of Drawings]

FIG. 1 is a perspective view illustrating a display apparatus according to various embodiments;
FIG. 2 is an exploded perspective view illustrating main components of the display apparatus of FIG. 1 according to various embodiments;
FIG. 3 is an enlarged cross-sectional view of various components of a display module of the display apparatus illustrated FIG. 1 according to various embodiments;
FIG. 4 is a rear perspective view of a display module of the display apparatus illustrated in FIG. 1 according to various embodiments;
FIG. 5 is a perspective view of various components of a display module illustrated in FIG. 1 according to various embodiments;
FIG. 6 is a cross-sectional view of various components of the display apparatus of FIG. 1 in a third direction according to various embodiments;
FIG. 7 is an enlarged cross-sectional view of various components illustrated in FIG. 6 according to various embodiments;
FIG. 8 is a diagram illustrating an example process of manufacturing a display apparatus according to various embodiments;
FIG. 9 is a diagram illustrating an example process of manufacturing the display apparatus after FIG. 8 according to various embodiments;
FIG. 10 is a diagram illustrating an example process of manufacturing the display apparatus after FIG. 9 according to various embodiments;
FIG. 11 is a diagram illustrating an example process of manufacturing the display apparatus after FIG. 10 according to various embodiments; and
FIG. 12 is a diagram illustrating an example process of manufacturing the display apparatus after FIG. 11 according to various embodiments.

### [Best Mode]

Thevarious example embodiments described in the disclosure and shown in the drawings are merely illustrative and are not intended to represent all aspects of the present disclosure, such that various equivalents and modifications may be made without departing from the spirit of the present disclosure.

An expression used in the singular encompasses the expression of the plural unless it has a clearly different meaning in the context. Also, shapes and sizes of elements in the drawings may be exaggerated or reduced for convenience of explanation.

Regarding the description of the drawings, like reference numerals may be used for like or related elements throughout the drawings.

The singular form of a noun corresponding to an item may include one or more items unless the context states otherwise.

Throughout the disclosure, "A or B", "at least one of A and B", "at least one of A or B", "A, B or C", "at least one of A, B and C", and " at least one or A, B, or C" may each include any one or all the possible combinations of A, B and C.

The term "and/or" is interpreted to include a combination or any of associated elements.

Terms such as "first" or "second" are used to distinguish one component from other components and, therefore, the components are not limited by the terms in any other aspect (e.g., importance or order).

When an element (e.g., first element) is mentioned as being "coupled" or "connected" to another element (e.g., second element) with or without an adverb "functionally" or "communicatively", it means that the element may be connected to the other element directly (e.g., by wires), wirelesses, or via a third element.

The terms such as "including" or "having" are intended to indicate the existence of features, numbers, processes, operations, components, parts, or combinations thereof in the disclosure, and are not intended to preclude the possibility that one or more other features, numbers, processes, operations, components, parts, or combinations thereof may exist or may be added.

When an element is mentioned as being "connected to", "coupled to", "supported on", or "contacting" another element, it includes not only a case that the elements are directly connected to, coupled to, supported on or contact each other but also a case that the elements are connected to, coupled to, supported on or contact each other through a third element.

When an element is mentioned as being located "on" another element, it implies not only that the element is in direct contact with the other element but also that a third element exists between the two elements.

In addition, throughout the disclosure, the term 'identical' indicates that one element has similar physical properties within a certain range. Furthermore, 'identical' may refer, for example, to 'substantially identical.' The term 'substantially identical' should be understood to refer, for example, to differences within the tolerance range of manufacturing errors or within a range that not affecting the value or reference value are considered to fall within the scope of 'identical'.

Hereinafter, various example embodiments according to the present disclosure will be described in greater detail with reference to the accompanying drawings.

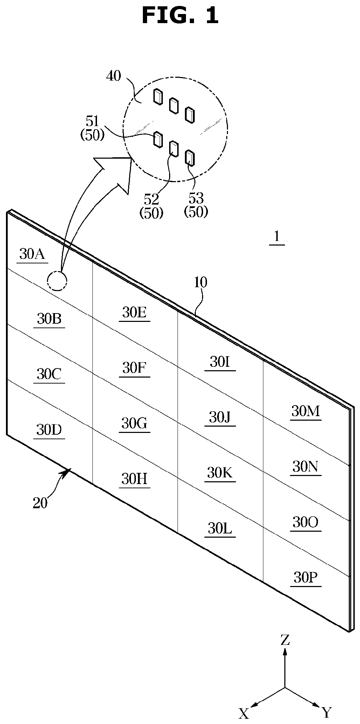

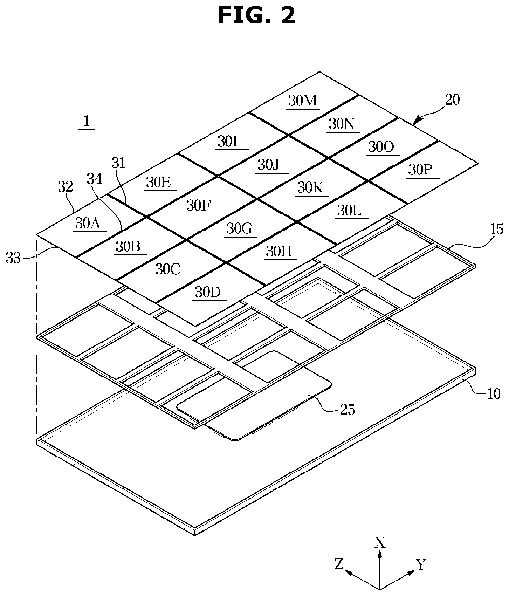

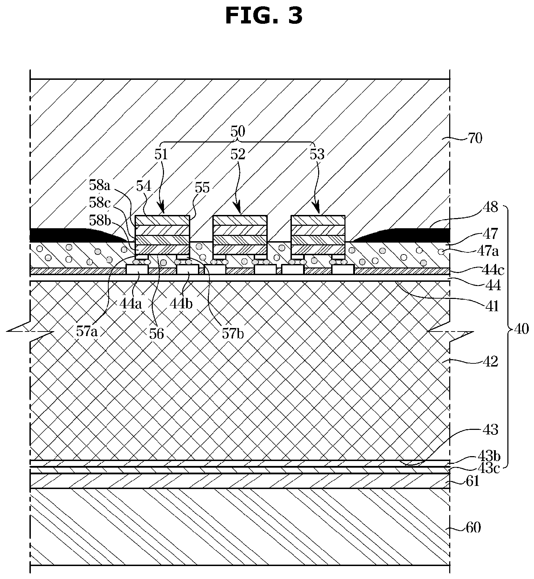

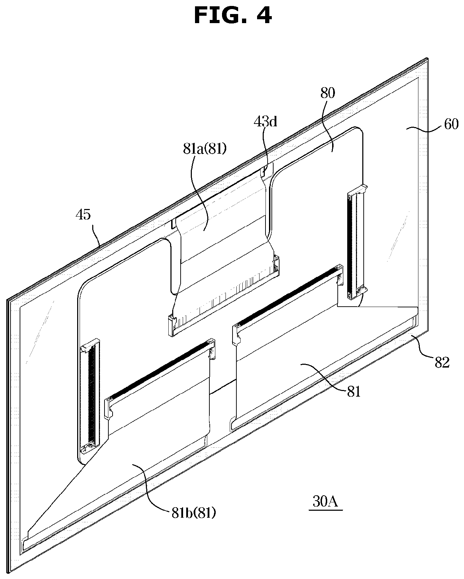

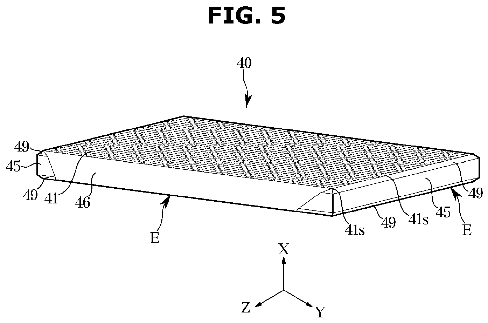

FIG. 1 is a perspective view illustrating a display apparatus according to various embodiments. FIG. 2 is an exploded perspective view illustrating various components of the display apparatus of FIG. 1 according to various embodiments. FIG. 3 is an enlarged cross-sectional view illustrating various components of a display module illustrated FIG. 1 according to various embodiments. FIG. 4 is a rear perspective view of a display module of the display apparatus illustrated in FIG. 1 according to various embodiments. FIG. 5 is a perspective view illustrating various components of a display module illustrated in FIG. 1 according to various embodiments.

Various components of a display apparatus 1 such as a plurality of inorganic light-emitting devices 50 illustrated in the drawings, are micro-sized components of several µm to several hundred µm, and the scale of some components (such as a plurality of inorganic light-emitting devices 50 and black matrix 48) are exaggerated for the convenience of explanation.

The display apparatus 1 is an apparatus configured to display information, references, data, and the like as text, figures, graphs, images, and the like, and TVs, PCs, mobile devices, digital signages, and the like may be implemented as the display apparatus 1.

According to an embodiment of the present disclosure, as shown in FIGS. 1 and 2, a display apparatus 1 may include a display panel 20 configured to display an image, a power supply (not shown) configured to supply power to the display panel 20, a main board 25 configured to control the overall operation of the display panel 20, a frame 15 configured to support the display panel 20, and a rear cover 10 covering the rear surface of the frame 15.

The display panel 20 may include a plurality of display modules 30A to 30P, a drive board (not shown) configured to drive each of the display modules 30A to 30P, and a timing controller (TOCN) board configured to generate timing signals required to control each of the display modules 30A to 30P.

The rear cover 10 may support the display panel 20. The rear cover 10 may be installed on the floor via a stand (not shown) or on a wall via a hanger (not shown).

The plurality of display modules 30A to 30P may be arranged in upward and downward orientations and leftward and rightward orientations to be adjacent to each other. The plurality of display modules 30A to 30P may be arranged in a M * N matrix form. Although 16 display modules 30A to 30P are arranged in a 4 * 4 matrix form, the number and the arrangement method of the plurality of display modules 30A to 30P are not limited.

The plurality of display modules 30A to 30P may be installed on the frame 15. The plurality of display modules 30A to 30P may be installed on the frame 15 by various known methods such as a magnetic force using magnets or a mechanical fitting structure. The rear cover 10 may be coupled to the rear of the frame 15, and the rear cover 10 may comprise the rear exterior appearance of the display apparatus 1.

The rear cover 10 may include a metallic material. Accordingly, heat generated in the plurality of display modules 30A to 30P and the frame 15 is easily transferred to increase heat dissipation efficiency of the display apparatus 1.

The display apparatus 1 according to an embodiment of the present disclosure may be implemented as a large screen by tiling the plurality of display modules 30A to 30P.

Each single display module among the plurality of display modules 30A to 30P may be applied to the display apparatus. For example, the display modules 30A to 30P may be applied, as a single unit, to wearable devices, portable devices, handheld devices, and electronic products or electrical components that require various displays. The display modules may be applied to display apparatuses such as monitors for personal computers (PCs), high resolution TVs and signages, and electronic displays by multiple assembly arrangements in matrix types.

The plurality of display modules 30A to 30P may have the same configuration. Therefore, descriptions of one display module given below may also be applied to all other displays in the same manner.

Because all of the plurality of display modules 30A to 30P are formed substantially identically, hereinafter, a first display module 30A will be described as a representative example for the respective plurality of display modules 30A to 30P.

For example, to avoid redundant descriptions, a display module 30, a substrate 40, and a front cover 70 will be described as representative components of the plurality of display modules 30A to 30P.

In addition, if required, among the plurality of display modules 30A to 30P, the first display module 30A and a third display module 30E disposed adjacent to the first display module 30A in a second direction (Y) or a second display module 30B disposed adjacent thereto in a third direction (Z) will be described.

The first display module 30A, as an example of the plurality of display modules 30A to 30P, may be formed as a quadrangle type. The first display module 30A may be provided as a rectangle type or a square type.

Therefore, the first display module 30A may have edges 31, 32, 33, and 34 in upward and downward orientations and leftward and rightward orientations based on a first direction (X) that is a forward direction.

As shown in FIG. 3, each of the plurality of display modules 30A to 30P may include a substrate 40, and a plurality of inorganic light-emitting devices 50 mounted on the substrate 40. The plurality of inorganic light-emitting devices 50 may be mounted on a mounting surface 41 of the substrate 40 facing in the first direction (X). In FIG. 3, a thickness of the substrate 40 in the first direction (X) was exaggeratedly illustrated.

The substrate 40 may be formed as a quadrangle type. As described above, each of the plurality of display modules 30A to 30P may be provided as a quadrangle type, and the substrate 40 may be formed as a quadrangle type to correspond thereto.

The substrate 40 may be provided as a rectangle type or a square type.

Therefore, based on the first display module 30A as an example, the substrate 40 may have 4 edges E corresponding to the edges 31, 32, 33, and 34 of the first display module 30A formed in upward and downward orientations and leftward and rightward orientations based on the first direction (X) that is the forward direction (See FIG. 5).

The first display module 30A may include a right edge 31, an upper edge 32, a left edge 33, and a lower edge 34 based on the first direction (X) that is the forward direction where a screen of the first display module 30A is displayed. The right edge 31 and left edge 33 may be disposed to face each other in the second direction (Y), e.g., leftward and rightward orientations, and the upper edge 32 and the lower edge 34 may be disposed to face each other in the third direction (Z), e.g., upward and downward orientations.

The substrate 40 may include a substrate body 42, a mounting surface 41 of one surface of the substrate body 42, a rear surface 43 of the other surface of the substrate body 42 and disposed on the opposite site to the mounting surface 41, and a side surface 45 disposed between the mounting surface 41 and the rear surface 43.

The side surface 45 may form side ends the substrate 40 in the second direction (Y) and the third direction (Z) which are perpendicular to the first direction (X).

The substrate 40 may have chambers 49 formed between the mounting surface 41 and the side surface 45 and between the rear surface 43 and the side surface 45.

The chamfers 49 may prevent/reduce the substrates from being damaged by collision therebetween while the plurality of display modules 30A to 30P are arranged.

The edge E of the substrate 40 may include the side surface 45 and the chamfer 49.

The substrate 40 may include a thin film transistor (TFT) layer 44 formed on the substrate body 42 to drive the inorganic light-emitting devices 50. The substrate body 42 may include a glass substrate. That is, the substrate 40 may include a chip on glass (COG) type substrate. First and second pad electrodes 44a and 44b configured to electrically connect the inorganic light-emitting devices 50 to the TFT layer 44 may be formed on the substrate 40.

A thin film transistor of the TFT layer 44 is not limited to a specific structure or type but may vary according to various embodiments. For example, the TFT of the TFT layer 44 according to an embodiment of the present disclosure may be implemented not only as a low temperature poly silicon (LTPS) TFT, an oxide TFT, or a poly silicon (or a-silicon, Si) TFT, but also as an organic TFT, a graphene TFT, and the like.

In addition, in the case where the substrate body 42 of the substrate 40 is formed as a silicon wafer, the TFT layer 44 may be replaced with a complementary metal-oxide semiconductor (CMOS) type transistor, an n-type metal-oxide-semiconductor field-effect transistor (MOSFET), or a p-type MOSFET.

The plurality of inorganic light-emitting devices 50 may be formed of an inorganic material and may include an inorganic light-emitting device having a size of several µm to several tens µm in width, length, and height. In the micro- inorganic light-emitting device, a size of the shortest one among the width, length, and height may be 100 µm or less. For example, the inorganic light-emitting device 50 may be picked up from a sapphire or silicon wafer and directly transferred onto the substrate 40. The plurality of inorganic light-emitting devices 50 may be picked up and transferred by an electrostatic method using an electrostatic head or by a stamp method using an elastic polymer material such as PDMS or silicone as a head.

The plurality of inorganic light-emitting devices 50 may include a light-emitting structure including an n-type semiconductor 58a, an active layer 58c, a p-type semiconductor 58b, a first contact electrode 57a, and a second contact electrode 57b.

Although not shown in the drawings, one of the first contact electrode 57a and the second contact electrode 57b may be electrically connected to the n-type semiconductor 58a and the other may be electrically connected to the p-type semiconductor 58b.

The first contact electrode 57a and the second contact electrode 57b may be disposed horizontally and may be in the form of a flip chip arranged in the same direction (opposite to the light-emitting direction).

The inorganic light-emitting device 50 may have a light-emitting surface 54 to face in the first direction (X) when mounted on the mounting surface 41, a side surface 55, and a bottom surface 56 disposed on the opposite side of the light-emitting surface 54, and the first contact electrode 57a and the second contact electrode 57b may be formed on the bottom surface 56.

For example, the contact electrodes 57a and 57b of the inorganic light-emitting device 50 may be disposed on the opposite site of the light-emitting surface 54, and thereby being disposed on the site opposite to the direction where light is emitted.

The contact electrodes 57a and 57b may be disposed to face the mounting surface 41 and to be electrically connected to the TFT layer 44, and the light-emitting surface 54 may be disposed to emit light in a direction opposite to the direction where the contact electrodes 57a and 57b are disposed.

Therefore, in the case where light is generated in the active layer 58c is emitted in the first direction (X) through the light-emitting surface 54, light may be emitted in the first direction (X) without interference of the first contact electrode 57a or the second contact electrode 57b.

For example, the first direction (X) may refer to a direction where the light-emitting surface 54 is arranged to emit light.

The first contact electrode 57a and the second contact electrode 57b may be electrically connected to the first pad electrode 44a and the second pad electrode 44b formed on the mounting surface 41 of the substrate 40, respectively.

The inorganic light-emitting device 50 may be directly connected to the pad electrodes 44a and 44b via an anisotropic conductive layer 47 or a joining member such as solder.

An anisotropic conductive layer 47 may be formed on the substrate 40 to mediate electrical connection between the contact electrodes 57a and 57b and the pad electrodes 44a and 44b. The anisotropic conductive layer 47, prepared by adhering an anisotropic conductive adhesive to a protective film, may have a structure in which conductive balls 47a are dispersed in an adhesive resin. The conductive ball 47a is a conductive sphere surrounded with a thin insulating film and conductors may be electrically connected to each other in the case where the insulating film is broken by a pressure.

The anisotropic conductive layer 47 may include an anisotropic conductive film (ACF) in an film form and an anisotropic conductive paste (ACP) in a paste form.

According to an embodiment of the present disclosure, the anisotropic conductive layer 47 may be provided as an anisotropic conductive film.

Upon application of a pressure to the anisotropic conductive layer 47 while mounting the plurality of inorganic light-emitting devices 50 on the substrate 40, the insulating layer of the conductive balls 47a breaks so that the contact electrodes 57a and 57b of the inorganic light-emitting device 50 may be electrically connected to the pad electrodes 44a and 44b of the substrate 40.

However, although not shown in the drawings, the plurality of inorganic light-emitting devices 50 may be mounted on the substrate 40 by solder (not show) instead of the anisotropic conductive layer 47. After the inorganic light-emitting devices 50 are aligned on the substrate 40, the inorganic light-emitting devices 50 may be bonded to the substrate 40 by a reflow process.

The plurality of inorganic light-emitting devices 50 may include a red light-emitting device 51, a green light-emitting device 52, and a blue light-emitting device 53, and the light-emitting devices 50 may be mounted on the mounting surface 41 of the substrate 40 such that a series of a red light-emitting device 51, a green light-emitting device 52, and a blue light-emitting device 53 are assembled as a single unit. The series of the red light-emitting device 51, the green light-emitting device 52, and the blue light-emitting device 53 may comprise a single pixel. In this case, the red light-emitting device 51, the green light-emitting device 52, and the blue light-emitting device 53 may form sub pixels, respectively.

The red light-emitting device 51, the green light-emitting device 52, and the blue light-emitting device 53 may be arranged in a row at predetermined intervals as described in an embodiment or in a different pattern such as a triangular pattern.

The substrate 40 may include a light absorbing layer 44c to increase contrast by absorbing external light. The light absorbing layer 44c may be formed over the entire mounting surface 41 of the substrate 40. The light absorbing layer 44c may be formed between the TFT layer 44 and the anisotropic conductive layer 47.

The plurality of display modules 30A to 30P may further include a black matrix 48 formed between the plurality of inorganic light-emitting devices 50.

The black matrix 48 may perform a function of complementing the light absorbing layer 44c formed over the entire mounting surface 41 of the substrate 40. That is, the black matrix 48 absorbs external light to allow the substrate 40 to be seen black, thereby improving contrast of the screen.

The black matrix 48 may have a black-toned color.

In an embodiment, the black matrix 48 may be formed to be disposed between pixels each formed of a series of the red light-emitting device 51, the green light-emitting device 52, and the blue light-emitting device 53. However, the black matrix 48 may be formed to divide the light-emitting devices 51, 52, and 53, which are sub pixels, more finely.

The black matrix 48 may be formed in a grid shape having horizontal and vertical patterns to be located between the pixels.

The black matrix 48 may be formed by applying a light-absorbing ink onto the anisotropic conductive layer 47 and curing the ink by an ink-jet process, or by coating the anisotropic conductive layer 47 with a light-absorbing film.

For example, on the anisotropic conductive layer 47 formed over the entire mounting surface 41, the black matrix 48 may be formed between the plurality of inorganic light-emitting devices 50 in areas where the plurality of inorganic light-emitting devices 50 are not mounted.

The plurality of display modules 30A to 30P may include the front cover 70 disposed on the mounting surface 41 in the first direction (X) to cover the mounting surface 41 of each of the plurality of display modules 30A to 30P.

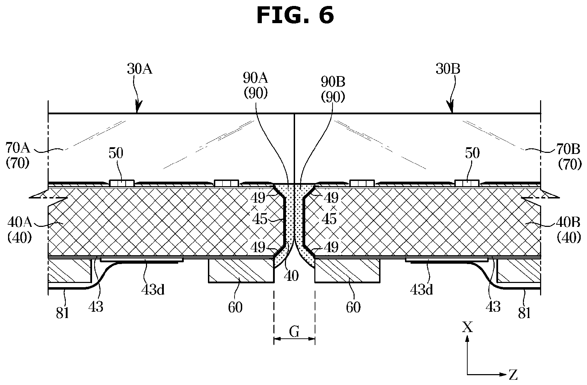

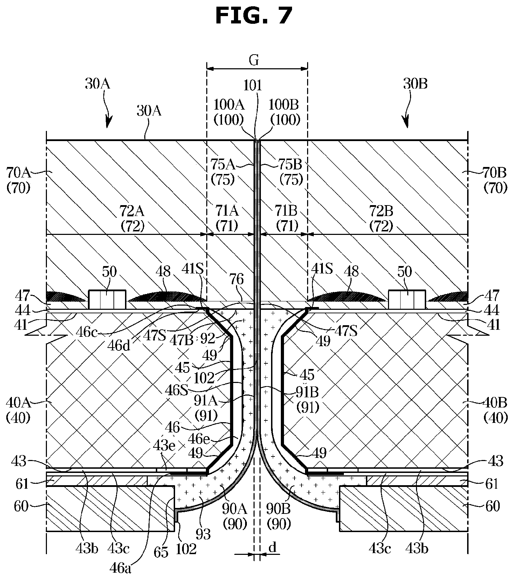

The front cover 70 may be provided in multiple units to be formed on each of the plurality of display modules 30A to 30P in the first direction (X) (See FIGS.6 and 7).

The plurality of display modules 30A to 30P may be assembled after forming individual front covers 70 are formed thereon, respectively. That is, in the case of the first display module 30A and the second display module 30B, as examples, among the plurality of display modules 30A to 30P, a first front cover 70A may be formed on the mounting surface 41 of the first display module 30A and a second front cover 70B may be formed on the mounting surface 41 of the second display module 30B.

The front cover 70 may protect the substrate 40 from external force or external moisture by covering the substrate 40.

A plurality of layers (not shown) of the front cover 70 may be provided as functional films having optical properties. This will be described in more detail below.

Some of the plurality of layers of the front cover 70 (not shown) may include a base layer (not shown) formed of an optical clear resin (OCR). The base layer (not shown) may be provided to support the other layers (not shown). The optical clear resin (OCR) may be in a very transparent state with a transmittance of 90% or more.

The optical clear resin (OCR) may improve visibility and image quality by increasing transmittance via low-reflection property. That is, while light loss occurs in a structure having an air gap due to a difference in refractive indices between a film layer and an air layer, light loss decreases in a structure using the optical clear resin (OCR) due to a reduced difference in the refractive indices, thereby improving visibility and image quality.

For example, the optical clear resin (OCR) may have advantages in terms of not only protecting the substrate 40 but also improving image quality.

Some of the plurality of layers (not shown) of the front cover 70 may have an adhesive layer (not shown) provided for adhesion between the front cover 70 and the mounting surface 41 of the substrate 40.

In general, the front cover 70 may be provided to have a height greater than a predetermined height in the first direction (X) where the mounting surface 41 or the light-emitting surface 54 faces.

The height of the front cover 70 may be for sufficiently filling gaps between the front cover 70 and the plurality of inorganic light-emitting devices 50 while the front cover 70 is formed on the substrate 40.

Each of the plurality of display modules 30A to 30P may include a metal plate 60 disposed on the rear surface 43 of the substrate 40.

In addition, the plurality of display modules 30A to 30P may include a rear adhesive tape 61 disposed between the rear surface 43 of the substrate 40 and the metal plate 60 for adhesion between the rear surface 43 and the metal plate 60, respectively.

The rear adhesive tape 61 may be provided as a double-sided adhesive tape, but is not limited thereto, and may be provided in the form of an adhesive layer instead of the tape form. That is, the rear adhesive tape 61, as an example of mediating adhesion between the metal plate 60 and the rear surface 43 of the substrate 40, is not limited to the tape but may be provided in various mediating shape.

The plurality of inorganic light-emitting devices 50 may be electrically connected to pixel driving wiring (not shown) formed on the mounting surface 41 and a front wiring layer (not shown) extending through the side surface 45 of the substrate 40 and formed of pixel driving wiring (not shown).

The front wiring layer (not shown) may be formed under the anisotropic conductive layer 47. The front wiring layer (not shown) may be electrically connected to the side wiring 46 formed on the side surface 45 of the substrate 40. The side wiring 46 may be provided as a thin film. The side wiring 46 may include a coating member 46e surrounding the side wiring 46 to prevent and/or reduce damage that may be caused in the case where the side wiring 46 is exposed to the outside (See FIG. 7).

The side wiring 46 may extend to the rear surface 43 of the substrate 40 in the third direction (Z) along the chamfer 49 and the side surface 45 of the substrate 40 in the third direction (Z). That is, the side wiring 46 may extend to the rear surface 43 of the substrate 40 from the upper edge 32 and on the lower edge 34 along the chamfer 49 and the side surface 45 of the substrate 40.

However, the disclosure is not limited thereto, and the side wiring 46 may extend to the rear surface 43 of the substrate 40, not in the third direction (Z), but in the second direction (Y), along the chamfer 49 and the side surface 45 of the substrate 40 in the second direction (Y).

In addition, the disclosure is not limited thereto, and the side wiring 46 may extend along edges E of the substrate 40 corresponding to at least two edges among the four edges 31, 32, 33, and 34 of the first display module 30A. The front wiring layer (not shown) may be connected to the side wiring 46 by a front pad (not shown) formed at the edge E side of the mounting surface 41.

The side wiring 46 may extend along the side surface 45 of the substrate 40 and may be connected to a rear wiring layer 43b of the rear surface 43. Specifically, the side wiring 46 may be connected to a rear pad 43e provided for electrical connection between the rear wiring layer 43b and the side wiring 46. The rear pad 43e may be formed at the edge E side of the rear surface 43 of the substrate 40.

An insulating layer 43c covering the rear wiring layer 43b may be formed on the rear wiring layer 43b in a direction where the rear surface of the substrate 40 faces.

For example, the plurality of inorganic light-emitting devices 50 may be electrically connected to the front wiring layer (not shown), the side wiring 46, and the rear wiring layer 43b sequentially.

As shown in FIG. 4, the display module 30A may include a drive circuit substrate 80 provided to electrically control the plurality of inorganic light-emitting devices 50 mounted on the mounting surface 41. The drive circuit substrate 80 may be formed as a printed circuit board. The drive circuit substrate 80 may be disposed on the rear surface 43 of the substrate 40 in the first direction (X). The drive circuit substrate 80 may be disposed on the metal plate 60 attached to the rear surface 43 of the substrate 40.

The display module 30A may include a flexible film 81 connecting the drive circuit substrate 80 with the rear wiring layer 43b for electrical connection of the drive circuit substrate 80 to the plurality of inorganic light-emitting devices 50.

For example, one end of the flexible film 81 may be disposed at the rear surface 43 of the substrate 40 and connected to a connection pad 43d electrically connected to the plurality of inorganic light-emitting devices 50.

The connection pad 43d may be electrically connected to the rear wiring layer 43b. Accordingly, the connection pad 43d may electrically connect the rear wiring layer 43b with the flexible film 81.

The flexible film 81 electrically connected to the connection pad 43d may transmit power and electric signals from the drive circuit substrate 80 to the plurality of inorganic light-emitting devices 50.

The flexible film 81 may be formed as a flexible flat cable (FFC), a chip on film (COF), or the like.

The flexible film 81 may include a first flexible film 81a and a second flexible film 81b disposed in the upward and downward orientations with respect to the first direction (X) that is a forward direction.

The first and second flexible films 81a and 81b are not limited thereto, and may be disposed, respectively, in the leftward and rightward orientations with respect to the first direction (X) or in at least two directions among the upward, downward, leftward, and rightward orientations.

The second flexible film 81b may be provided in multiple units. However, the disclosure is not limited thereto, and the second flexible film 81b may be provided as a single unit and the first flexible film 81a may also be provided in multiple units.

The first flexible film 81a may transmit data signal from the drive circuit substrate 80 to the substrate 40. The first flexible film 81a may be provided as a COF.

The second flexible film 81b may transmit power from the drive circuit substrate 80 to the substrate 40. The second flexible film 81b may be provided as an FFC.

However, the disclosure is not limited thereto, and the first and second flexible films 81a and 81b may be formed to opposite to each other.

Although not shown in the drawings, the drive circuit substrate 80 may be electrically connected the main board 25 (See FIG. 2). The main board 25 may be disposed behind the frame 15, and the main board 25 may be connected to the drive circuit substrate 80 by a cable (not shown) at a rear side of the frame 15.

A fixing member 82 may be disposed at the rear surface of the metal plate 60 for adhesion between the display modules 30A to 30P and the frame 15. The fixing member 82 may be provided as a double-sided adhesive layer. By the fixing member 82, the metal plate 60 of the rear of the display modules 30A to 30P may be directly adhered to the frame 15 so that the display modules 30A to 30P may be supported by the frame 15.

As described above, the metal plate 60 may be arranged to be in contact with the substrate 40. The metal plate 60 may be adhered to the substrate 40 by the rear adhesive tape 61 disposed between the rear surface 43 of the substrate 40 and the metal plate 60.

FIG. 5 illustrates an example of the substrate 40 from which components such as the anisotropic conductive layer 47 is removed for the convenience of description. In addition, although the side wiring 46 includes a coating member 46e that protects the side wiring 46 from the outside, the coating member 46e is not shown for the convenience of description.

The metal plate 60 may be formed of a metallic material with high thermal conductivity. For example, the metal plate 60 may be formed of an aluminum material.

Heat generated in the plurality of inorganic light-emitting devices 50 and the TFT layer 44 mounted on the substrate 40 may be transferred to the metal plate 60 along the rear surface 43 of the substrate 40 through the rear adhesive tape 61.

Accordingly, heat generated in the substrate 40 is easily transferred to the metal plate 60 and the temperature of the substrate 40 may be prevented/reduced from increasing above a certain temperature.

The plurality of display modules 30A to 30P may be arranged in various positions in the form of M * N matrix, respectively. Each of the display modules 30A to 30P is provided to be individually movable. In this regard, because each of the display modules 30A to 30P individually includes the metal plate 60, a constant level of heat dissipation performance may be maintained regardless of arranged positions of the display modules 30A to 30P, respectively.

A plurality of display modules 30A to 30P in various M * N matrix forms may comprise screens of the display apparatus 1 in various sizes. Accordingly, the overall heat dissipation performance of the display apparatus 1 may be improved via heat dissipation by individually dissipating heat from each of the display modules 30A to 30P respectively including the metal plate 60 according to an embodiment of the present disclosure compared to heat dissipation using a single metal plate.

In the case where a single metal plate is disposed in the display apparatus 1, a part of the metal plate may not be disposed at a position corresponding to some display modules based on the forward and backward orientations, and the metal plate may be disposed at a position where some display modules are not disposed, so that heat dissipation efficiency of the display apparatus 1 may decrease.

For example, because self-heat dissipation is possible in all of the display modules 30A to 30P via the respective metal plates 60, heat may be dissipated from each of the display modules 30A to 30P through each of the metal plates 60 regardless of the positions of the display modules 30A to 30P, so that the overall heat dissipation performance of the display apparatus 1 may be improved.

The metal plate 60 may be provided as a quadrangle type roughly corresponding to the shape of the substrate 40.

An area for the substrate 40 may be the same as or greater than that of the metal plate 60. In the case where the substrate 40 and the metal plate 60 are arranged parallel to each other in the first direction (X), 4 edges of the rectangle type substrate 40 may be formed to correspond to 4 edges of the metal plate 60 based on the center of the substrate 40 and the metal plate 60 or may be disposed outer positions based on the center of the substrate 40 and the metal plate 60.

The 4 edges E of the substrate 40 may be arranged at outer positions of the 4 edges E of the metal plate 60. That is, the area of the substrate 40 may be greater than that of the metal plate 60.

The substrate 40 and the metal plate 60 may be thermally expanded by heat transferred to each of the display modules 30A to 30P. Because the metal plate 60 has a higher thermal expansion coefficient than that of the substrate 40, an expansion value of the metal plate 60 is greater than an expansion value of the substrate 40.

In this regard, in the case where the 4 edges E of the substrate 40 correspond to or are disposed at inner positions than the 4 edges E of the metal plate 60, the edges of the metal plate 60 may protrude to an area outside the substrate 40.

Accordingly, gap separation lengths between the respective display modules 30A to 30P may become irregular due to thermal expansion of the metal plate 60 of the display modules 30A to 30P, and recognition of some seams may increase, so that screen integrity of the display panel 20 may be degraded.

However, in the case where the 4 edges E of the substrate 40 are disposed at outer positions than the 4 edges E of the metal plate 60, the 4 edges E the metal plate 60 do not protrude to an area outside the 4 edges E of the substrate 40 although the substrate 40 and the metal plate 60 are thermally expanded, so that the gap separation lengths between the respective display modules 30A to 30P may be maintained constantly.

According to an embodiment of the present disclosure, the area of the substrate 40 may be provided to approximately correspond to the area of the metal plate 60. Therefore, heat generated in the substrate 40 may not be trapped in a certain region but may be uniformly dissipated throughout the entire area of the substrate 40.

The metal plate 60 may be adhered to the rear surface 43 of the substrate 40 by the rear adhesive tape 61.

The rear adhesive tape 61 may be provided to have a size corresponding to the metal plate 60. For example, an area of rear adhesive tape 61 may correspond to an area of the metal plate 60. The metal plate 60 may be provided to have an approximately quadrangular shape and the rear adhesive tape 61 may have a quadrangular shape to correspond thereto.

Based on the center of the metal plate 60 and the rear adhesive tape 61, the edges of the rectangle type metal plate 60 may be formed to correspond to the edges of the rear adhesive tape 61.

Accordingly, the metal plate 60 and the rear adhesive tape 61 may be easily manufactured as a single combined structure, and thus manufacturing efficiency of the entire display apparatus 1 may be increased.

For example, in the case where the metal plate 60 as a single plate is cut into the number of units, the rear adhesive tape 61 may be adhered to the whole plate first before cutting the metal plate 60, and then the rear adhesive tape 61, together with the metal plate 60, may be cut into the number of units, thereby obtaining the effect of simplifying the manufacturing process.

Heat generated in the substrate 40 may be transferred to the metal plate 60 through the rear adhesive tape 61. Accordingly, the rear adhesive tape 61 may be provided to transfer heat generated in the substrate 40 to the metal plate 60 simultaneously adhering the metal plate 60 to the substrate 40.

Therefore, the rear adhesive tape 61 may include a material with high heat dissipation performance.

The rear adhesive tape 61 may include an adhesive material to adhere the substrate 40 to the metal plate 60.

The rear adhesive tape 61 may have a material with higher heat dissipation performance than a material with general adhesive. Therefore, heat may be efficiently transferred respectively to components between the substrate 40 and the metal plate 60.

The adhesive material of the rear adhesive tape 61 may be formed of a material with higher heat dissipation performance than a material comprising a common adhesive.

The material with higher heat dissipation performance may refer, for example, to a material having high thermal conductivity, high conductive continuity, and low specific heat, thereby efficiently transferring heat.

For example, the rear adhesive tape 61 may include a graphite material. However, the disclosure is not limited thereto, and the rear adhesive tape 61 may generally be formed of a material with higher heat dissipation performance.

The rear adhesive tape 61 may have greater ductility than that of the substrate 40 and the metal plate 60. Therefore, the rear adhesive tape 61 may be provided as a material with high ductility as well as adhesiveness and heat dissipation. The rear adhesive tape 61 may be formed as an inorganic double-sided tape. As described above, the rear adhesive tape 61 is formed as an inorganic double-sided tape, and thus a single layer may be provided between one surface in contact with the substrate 40 and the other surface in contact with the metal plate 60 without a base supporting the one surface and the other surface.

Because the rear adhesive tape 61 does not include the base, a material interfering with thermal conduction, is not included thereon and thus heat dissipation performance may be improved. However, the rear adhesive tape 61 is not limited to the inorganic double-sided tape, but may be provided as a heat dissipation tape with better heat dissipation performance than a general double-sided tape.

The rear adhesive tape 61 may be formed of a material with high ductility to absorb external forces received from the substrate 40 and the metal plate 60. Specifically, the ductility of the rear adhesive tape 61 may be greater than ductility of the substrate 40 and ductility of the metal plate 60.

Accordingly, in the case where external forces, which are generated by size difference between the substrate 40 and the metal plate 60 due to heat transferred to the substrate 40 and the metal plate 60, are transferred to the rear adhesive tape 61, the rear adhesive tape 61 itself is deformed, thereby preventing/reducing the external forces from being transferred to the other components.

The rear adhesive tape 61 may have a predetermined thickness in the first direction (X). In the case where the metal plate 60 expands by heat transferred thereto or contacts by cooling, the metal plate 60 may expand or contract in a direction perpendicular to the first direction (X), as well as the first direction (X), and accordingly external forces may be transferred to the substrate 40.

Because the metal plate 60 is formed to a size corresponding to the substrate 40 to cover the entire rear surface 43 of the substrate 40 as described above, the fixing member 82 may be disposed on the rear surface of the metal plate 60.

However, the disclosure is not limited thereto, and the fixing member 82 may be disposed on the rear surface 43 of the substrate 40. In this regard, the substrate 40 may be in direct contact with the frame 15 through the fixing member 82.

The metal plate 60 may be provided to cover only a part of the rear surface 43 of the substrate 40, and the fixing member 82 may be adhered to regions of the rear surface 43 of the substrate 40 not covered with the metal plate 60.

The fixing member 82 may be provided, preferably as a double-sided tape.

Hereinafter, the front cover 70, a side cover 90, and a side end member 100 will be described in greater detail.

FIG. 6 is a cross-sectional view illustrating various components of the display apparatus of FIG. 1 in the third direction according to various embodiments. FIG. 7 is an enlarged cross-sectional view illustrating various components illustrated in FIG. 6 according to various embodiments.

The term "upward and downward orientations" used in the following descriptions refers to the first direction (X) that is a direction where the mounting surface 41 faces based on the cross-sectional view of the display apparatus of FIG. 6. The first direction (X) may be aligned in the forward and backward orientations such that a display surface of a display apparatus faces a user while the display apparatus is installed, but hereinafter, the first direction (X) will be described based on the upward and downward orientations.

The front cover 70 may protect the substrate 40 from external forces, decrease visibility of the seam formed by a gap G between the plurality of display modules 30A to 30P, and reduce color deviation between the plurality of display modules 30A to 30P.

Each of the plurality of display modules 30A to 30P may include a side cover 90 disposed in the gap G formed between the plurality of display modules 30A to 30P in the case where the plurality of display modules 30A to 30P are arrayed.

The front cover 70 of each of the display modules 30A to 30P may be formed to extend to an area outside the substrate 40 of the plurality of display modules 30A to 30P to absorb light reflected by the gap G between the plurality of display modules 30A to 30P. The side end 75 of the front cover 70 may be provided to extend to an area outside the mounting surface 41.

For example, the front cover 70 may be provided to extend to an area outside the edge (or side end, edge 41S) of the mounting surface 41 of the substrate 40 in the second direction (Y) and the third direction (Z).

Although the gap G between the respective display modules 30A to 30P may be substantially formed between the side surfaces 45 of the substrates 40 of the display modules 30A to 30P, respectively, the gap G according to an embodiment of the present disclosure may refer to a non-display region that may be formed between the respective display modules 30A to 30P, and the meaning of the gap G formed between the plurality of display modules 30A to 30P may be understood as separation from an edge 41S of a mounting surface 41 of a substrate 40 of one of the plurality of display modules 30A to 30P to an edge 41S of a mounting surface 41 of a substrate 40 of an adjacent one of the plurality of display modules 30A to 30P.

Therefore, the gap G formed between the plurality of display modules 30A to 30P may refer to separation formed between the edge 41S of the mounting surface 41 of one of the display modules 30A to 30P and the edge 41S of the mounting surface 41 of another display module 30A to 30P adjacent thereto in the second direction (Y) or the third direction (Z).

Because the front cover 70 extending from each of the plurality of display modules 30A to 30P may be disposed in the gap G between the plurality of display modules 30A to 30P and absorb light emitted to the gap G or light reflected by the gap G, recognition of seams may be minimized/reduced.

As will be described in greater detail below, light emitted to the gap G may be absorbed by the side covers 90 of the plurality of display modules 30A to 30P disposed between the gaps G, thereby minimizing/reducing recognition of seams.

As shown in FIGS. 6 and 7, the front cover 70 may be provided to extend to an area outside the substrate 40 in the third direction (Z). Specifically, the front cover 70 may be provided to extend to an area outside the side surface 45 and the chamfer 49 in the third direction (Z).

Although one edge of the substrate 40 corresponding to a lower edge 34 of the first display module 30A will be described by way of example, the front cover 70 may extend to areas outside the 4 edges E of the substrate 40 in the second direction (Y) or the third direction (Z).

For example, the side end 75 of the front cover 70 corresponding to an edge of the front cover 70 may extend to an area outside the substrate 40 farther than the 4 edges E of the substrate 40, e.g., an area outside the mounting surface 41.

For example, although not shown in the drawings, the front cover 70 may include a plurality of layers having different optical properties. The plurality of layers may be stacked in the first direction (X), respectively. The plurality of layers may be bonded in the first direction (X) to comprise the front cover 70.

For example, one of the plurality of layers may be provided as an anti-glare layer. For example, the layer may be provided as a non-reflective layer or a mixed layer of an anti-glare layer and a non-reflective layer.

For example, another layer of the plurality of layers, different therefrom, may be provided as a light transmittance control layer. For example, the layer may be provided as a layer including different properties or materials or having different functions. For example, the layer may be provided as a circularly polarizer layer.

For example, the plurality of layers may be provided as a single layer. The single layer may be provided as a layer implementing all of the functions of the plurality of layers.

For example, the front cover 70 may include an adhesive layer. The adhesive layer may be disposed as the rearmost layer of the plurality of layers in the first direction (X) to be adhered to the mounting surface 41. The adhesive layer may be provided to have a predetermined height in the first direction (X) where the mounting surface 41 or the light-emitting surface 54 faces.

For example, when the adhesive layer is adhered to the substrate 40, and gaps that may be formed between the adhesive layer and the plurality of inorganic light-emitting devices 50 may be sufficiently filled with the adhesive layer having a predetermined height.

For example, the adhesive layer, as a separate component from the front cover 70, may be disposed between the front cover 70 and the mounting surface 41 to bond the front cover 70 to the mounting surface 41.

Accordingly, the front cover 70 may be in close contact with the mounting surface 41 and protect components mounted on the mounting surface 41, and thus the front cover 70 may be directly adhered to the substrate 40 without an additional molding formed between the front cover 70 and the substrate 40 in the display module 30.

The front cover 70 may be provided to diffusely reflect external light incident thereon to prevent/reduce external light from being reflected and dazzling user's eyes).

By diffusely reflecting external light incident thereon, the glare phenomenon may be reduced, and accordingly the contrast of the screen displayed on the display panel 20 may be improved.

In addition, the front cover 70 may be provided to reduce transmittance of external light incident thereon or external light reflected by the substrate 40 and the gap G.

The front cover 70 may include a material reducing transmittance of light to transmit at least a part of light to the substrate 40 or absorb at least a part of light reflected by the substrate 40 and traveling in the first direction (X).

In the production of multiple substrates, some substrates may have different colors due to problems during the production process. Accordingly, substrates having unique different colors may be tiled to comprise a single display panel.

As described above, the front cover 70 according to an embodiment of the present disclosure may absorb at least a part of light reflected by the substrate 40 and transmitted to the outside to increase the screen integrity of the display panel 20.

For example, the front cover 70 may reduce color deviation of the display modules 30A to 30P caused during the manufacturing process of the plurality of display modules 30A to 30P by decreasing transmittance of external light .

The front cover 70 may increase the contrast of the screen displayed on the display panel 20 by preventing/reducing external light incident on the display panel 20 from being transmitted to the substrate 40, additionally absorbing a part of external light incident on the display panel 20, or absorbing a part of external light reflected by the substrate 40 and transmitted to the outside of the display panel 20. Such different optical actions may be realized by the above-described plurality of layers.

For example, the front cover 70 may be disposed in front of the substrate 40 in the first direction (X) to improve the contrast of the screen displayed on the display panel 20 that may be reduced by external light.

As described above, in the case of the display module 30 according to an embodiment of the present disclosure, the front cover 70 may be provided to extend to an area outside the substrate 40 in the third direction (Z).

Accordingly, a part of light introduced into the gap G formed between the plurality of display modules 30A to 30P may be blocked by at least a part of the front cover 70 disposed on the gap G, and external light incident on the gap G or external light reflected by the gap G may be at least partially absorbed by the front cover 70 disposed on the gap G so as not to be transmitted to the outside. Therefore, visibility of a seam formed in the gap G may decrease, and with the decrease in visibility of the seam, the screen integrity of the screen displayed on the display panel 20 may be improved.

For example, the side end 75 of the front cover 70 in the third direction (Z) may be disposed at outer position of the edge 41S of the mounting surface 41 in the second direction (Y) or in the gap G.

Accordingly, the front cover 70 may have a first region 71 disposed on an area outside the edge 41S of the mounting surface 41 or on the gap G, and a second region 72 disposed on the mounting surface 41 in the third direction (Z).

The front cover 70 may be divided into the first region 71 and the second region 72 in the third direction (Z) by the gap G.

Because the first region 71 of the front cover 70 is disposed on the gap G, external light emitted to the gap G may be blocked by the first region 71 of the front cover 70, and transmission of light reflected by the gap G to the outside may be prevented/reduced, so that visibility of seams that are boundaries of the plurality of display modules 30A to 30P formed by the gap G may be reduced resulting in improvement of screen integrity of the display panel 20.

As described above, the front cover 70 may be provided to extend to an area outside the 4 edges E of the mounting surface 41 of the substrate 40, and thus visibility of seams that may be formed at the edges of the plurality of display modules 30A to 30P may be reduced.

The first display module 30A and the second display module 30B will be described by way of example, the first region 71A of the front cover 70A of the first display module 30A extending from the first display module 30A may be disposed on the gap G formed between the first display module 30A and a second display module 30B.

On the gap G, a side end 75A of the front cover 70A of the first display module 30A and a side end 75B of a front cover 70B of the second display module 30B adjacent to the first display module 30A may be disposed.

In addition, in the gap G, the side surfaces 45 and the chamfers 49 of the first display module 30A and the second display module 30B may be disposed.

A second region 72A of the front cover 70A of the first display module 30A may be disposed on the mounting surface 41 of the first display module 30A.

A first region 71B of a front cover 70B of the second display module 30B extending from the second display module 30B may be disposed on the gap G between the first display module 30A and the second display module 30B, and a second region 72B of the front cover 70B of the second display module 30B may be disposed on the mounting surface 41 of the second display module 30B.

For example, on the gap G formed between the first display module 30A and the second display module 30B, the first region 71A of the front cover 70A of the first display module 30A and the first region 71B of the front cover 70B of the second display module 30B may be disposed side by side in the third direction (Z).

A length of each of the first region 71A of the front cover 70A of the first display module 30A and the first region 71B of the front cover 70B of the second display module 30B extending in the third direction (Z) may be about a half or less of that of the gap G.

Accordingly, a sum of the length of the first region 71A of the front cover 70A of the first display module 30A and the length of the first region 71B of the front cover 70B of the second display module 30B may be provided to approximately correspond to or less than the length of the gap G.

As described above, on the gap G between the first display module 30A and the second display module 30B, the first region 71A of the front cover 70A of the first display module 30A and the first region 71B of the front cover 70B of the second display module 30B may be disposed.

External light incident on the display panel 20 may be diffusely reflected to the outside of the display panel 20 or partially absorbed by the first region 71A of the front cover 70A of the first display module 30A and the first region 71B of the front cover 70B of the second display module 30B while being transmitted through the first region 71A of the front cover 70A of the first display module 30A and the first region 71B of the front cover 70B of the second display module 30B, so that an amount of light arriving at the gap G may decrease and visibility of boundaries between the first display module 30A and the second display module 30B by the gap G may be reduced.

Light reflected by the gap G and traveling toward the outside the display panel 20 may be diffusely reflected to the outside of the display panel 20 or partially absorbed by the first region 71A of the front cover 70A of the first display module 30A and the first region 71B of the front cover 70B of the second display module 30B while being transmitted to the first region 71A of the front cover 70A of the first display module 30A and the first region 71B of the front cover 70B of the second display module 30B, so that an amount of light transmitted out of the display panel 20 may be reduced. Therefore, visibility of boundaries between the first display module 30A and the second display module 30B by the gap G may be reduced.

For example, the screen integrity of the display panel 20 may be improved by reducing the amount of external light incident on the gap G formed between the plurality of display modules 30A to 30P and absorbing at least a part of external light reflected by the gap G.

Even though a substrate 40A of the first display module 30A and a substrate 40B of the second display module 30B have different colors, the substrate 40A of the front cover 70A of the first display module 30A and the front cover 70B of the second display module 30B absorb at least a part of light reflected when the substrate 40A of the first display module 30A and the substrate 40B of the second display module 30B are shown from the outside by reflection of external light, so that intrinsic colors of the substrate 40A of the first display module 30A and the substrate 40B of the second display module 30B are not recognized from the outside, resulting in improvement of the screen integrity of the display panel 20.

The display module 30A may include the side cover 90 disposed under the front cover 70 in a direction where the mounting surface 41 faces and provided on the side surface 45 of the substrate 40.

For example, the side end 47S of the anisotropic conductive layer 47 of the display module 30 may be aligned on the same line as the side end 75 of the front cover 70 in the first direction (X).

The anisotropic conductive layer 47 may be provided in the form of anisotropic conductive film. The anisotropic conductive layer 47 may be provided on the TFT layer 44 in the form of a film to be bonded to the TFT layer 44. The anisotropic conductive layer 47 is provided in the form of a film and an area of the anisotropic conductive layer 47 may be greater than that of the substrate 40.

For example, after the anisotropic conductive layer 47 is bonded to the TFT layer 44, the front cover 70 covers the mounting surface 41 of the substrate 40, and then a process of simultaneously cutting the anisotropic conductive layer 47 and the front cover 70 may be performed. By the cutting process such as laser cutting, the anisotropic conductive layer 47 may be cut together with the front cover 70 such that the side end 47S of the anisotropic conductive layer 47 is aligned on the same line as the side end 75 of the front cover 70 in the first direction (X).

The side cover 90 may be disposed in a space formed by a lower surface 47B of the anisotropic conductive layer 47 in the first direction (X) and a side surface of the substrate 40 in the third direction (Z).

The side cover 90 may be provided to extend from the lower surface 47B of the anisotropic conductive layer 47 to the side surface 65 of the metal plate 60 in the first direction (X).

One end 92 of the side cover 90 in the first direction (X) may be provided in contact with the lower surface 47B of the anisotropic conductive layer 47, and the other end 93 of the side cover 90 in the first direction (X) may be provided in contact with the side surface 65 of the metal plate 60.

Because the side cover 90 extends from one end 92 to the other end 93, the side cover 90 may be provided to surround not only the side surface 45 but also the chamfer 49 formed between the mounting surface 41 and the side surface 45.

Because the side cover 90 is provided to surround the chamfer 49 formed between the mounting surface 41 and the side surface 45 and the chamfer 49 formed between the side surface 45 and the rear surface 43, the side cover 90 may cover all spaces that may be formed between a lower surface 76 of the front cover 70 and the metal plate 60.

The side cover 90 may prevent/reduce foreign substances or moisture from entering the space between the substrate 40 and the front cover 70 and between the substrate 40 and the anisotropic conductive layer 47 from the outside.

The side cover 90 may prevent/reduce foreign substances or moisture from entering the space between the substrate 40 and the metal plate 60 from the outside.

The side wiring 46 may include a first end 46a connected to the rear pad 43e, a second end 46c connected to the front pad (not shown), a first end portion 46b including the first end 46a as an adjacent region to the first end 46a in the side wiring 46, and a second end portion 46d including the second end 46c as an adjacent region to the second end 46c in the side wiring 46.

Because one end 92 of the side cover 90 in the first direction (X) is provided to be in contact with the lower surface 76 of the side cover 90 and the lower surface 47B of the anisotropic conductive layer 47, and the other end 93 of the side cover 90 in the first direction (X) is provided to cover at least a portion of the metal plate 60 in the first direction (X), the side cover 90 may seal the entire side surface 45 and side wiring 46, thereby preventing/reducing liquids such as moisture from entering from the outside.

For example, the side end 47S of the anisotropic conductive layer 47 of the display module 30 may be disposed at an inner position than the side end 75 of the front cover 70 in the third direction (Z).

For example, after the anisotropic conductive layer 47 is bonded to the TFT layer 44, a process of cutting the anisotropic conductive layer 47 may be performed to make the area of the anisotropic conductive layer 47 correspond to the area of the substrate 40. By the cutting process such as laser cutting, the anisotropic conductive layer 47 may be cut such that the area of the anisotropic conductive layer 47 corresponds to that of the substrate 40.

For example, to prevent/reduce damage to the substrate 40 that may occur during the cutting process, a position where the anisotropic conductive film is cut may be an area outside the side surface 45 or the side end 46S of the side wiring 46. The side end 47S of the anisotropic conductive layer 47 may be formed outside the substrate 40.

For example, the side cover 90 may be disposed in a space formed by the lower surface 76 of the first region 71 of the front cover 70 in the first direction (X), the lower surface 47B of the anisotropic conductive layer 47, and the side surfaces of the substrate 40 in the third direction (Z). The lower surface 76 of the first region 71 refers to the rear surface of the adhesive layer (not shown) formed at the rearmost layer of the front cover 70 as at least a portion of the lower surface of the entire front cover 70.

The side surfaces 45 of the substrate 40 may be provided to correspond to 4 edges E of the mounting surface 41, and the first region 71 of the front cover 70 may extend to an area outside the 4 edges 41S of the mounting surface 41 in the second direction (Y) and the third direction (Z) where the mounting surface 41 extends.

For example, the side cover 90 may be provided to surround an area under the first region 71 in the first direction (X) along the perimeter of the 4 edges 41S of the mounting surface 41 and the side surfaces 45 corresponding to the 4 edges 41S. The side cover 90 may be provided to seal all edges where the substrate 40 is bonded to the front cover 70.

The side cover 45 may cover the lower surface 76 of the first region 71 and the side surfaces 45 in all directions perpendicular to the first direction (X). Accordingly, binding strength between the front cover 70 and the substrate 40 may be improved, and the front cover 70 and the side surfaces 45 of the substrate 40 may be protected against the external forces.

For example, the side cover 90 may be provided to surround areas under the first region 71 at some edges in the first direction (X) among the 4 edges 41S of the mounting surface 41 and side surfaces 45 corresponding to the some edges. The side cover 90 may be provided to seal a part of the edge where the substrate 40 is bonded to the front cover 70. The side cover 90 may be provided to surround only side surfaces 45 on which the side wiring 46 extends among the 4 side surfaces 45 to focus on protecting the side wiring 46.

For example, the side cover 90 may be disposed only on the side surface 45 corresponding to the upper edge 32 and the lower edge 34 on which the side wiring 46 extends. In order to preferentially protect the side wiring 46 and electric components connected to the side wiring 46 which are vulnerable to damage caused by introduction of foreign substances or electrostatic discharge, the side cover 90 may be provided to cover only the side surfaces 45 where the side wiring 46 extends among the 4 side surfaces 45.

Because electric components may be damaged by currents flowing into the plurality of electric components mounted on the substrate 40 due to electrostatic discharge that may occur in the plurality of display modules 30A to 30P, the side cover 90 may seal the substrate 40 from the outside to prevent/reduce damage to the electric components, thereby blocking charges generated by the electrostatic discharge from entering the substrate 40.

For example, because the substrate 40 is sealed by the front cover 70 and the side cover 90, charges generated by the electrostatic discharge cannot pass through the front cover 70 and the side cover 90 to prevent/block the charges from flowing into the substrate 40, and the charges flowing on the front cover 70 and the side cover 90 are guided to the metal plate 60 in contact with the side cover 90 to provide a flow path of currents by electrostatic discharge. Accordingly, electrostatic discharge (ESD) withstand voltage of the electric components mounted on the substrate 40 may be increased.

As described above, the display module 30A may be disposed under the front cover 70 in a direction where the mounting surface 41 faces.

The one end 92 of the side cover 90 may be disposed under the lower surface 76 of the first region 71 in the first direction (X). This is to avoid placing the side cover 90 on the path of light emitted from the plurality of inorganic light-emitting devices 50.

The side end 75 of the front cover 70 in the third direction (Z) and the side end 91 of the side cover 90 in the third direction (Z) may be aligned on the same line in the first direction (X).

For example, the front cover 70 and the side cover 90 may be simultaneously cut during the manufacturing process of the first display module 30A. Accordingly, in the case of arraying the plurality of display modules 30A to 30P, separation formed between the plurality of display modules 30A to 30P may be minimized/reduced, and seams visible by the separation between the plurality of display modules 30A to 30P may be minimized/reduced.

The side cover 90 may include a material absorbing light. For example, the side cover 90 may be formed of an opaque or translucent material. For example, the side cover 90 may be formed of a material having a black-toned color. The side cover 90 may have a darker color than that of the front cover 70. For example, the side cover 90 may be provided to have a similar color to that of the black matrix 48. Accordingly, light incident on the side cover 90 may not be reflected by the light-absorbing material of the side cover 90 but may be absorbed by the side cover 90.

For example, the side cover 90 may include a photosensitive material. For example, the side cover 90 may be formed of an optical clear resin (OCR). For example, upon irradiation of external light having a wavelength other than a wavelength of visible light, such as ultraviolet (UV) light, a photosensitive material may be changed in color to a darker color due to changes in physical properties thereof. The side cover 90 is formed of a material capable of absorbing light as the material turns to a darker color upon irradiation of UV light to the side cover 90 during a manufacturing process.

The side cover 90 may be made of a moisture-proof material preventing/reducing a solution such as moisture from infiltrating.

As described above, because the side cover 90 is provided to seal edges of the display modules 30A to 30P, all of the side wiring 46, the first end portion 46b of the side wiring 46 and the side surface 45, and the rear pad 43e connected to the side wiring 46 may be covered thereby, so that infiltration of a solution such as moisture from the outside may be prevented/reduced.

For example, the side cover 90 may be replaced with a water-proof material against liquids to prevent/reduce a solution from being absorbed into the side cover 90 and flowing to the side wiring 46, the rear pad 43e, or the side surface 45.

As described above, due to the coating member 46e surrounding the side wiring 46, entering of an external solution through the side wiring 46 may be prevented /reduced even when the side wiring 46 is exposed to the outside. However, in the case where the external solution is an alkaline solution such as a cleaning solution, the coating member 46e may be removed by the alkaline solution causing damage to the side wiring 46. The side cover 90 may cover the entire area of the side wiring 46, thereby preventing/reducing damage to the side wiring 46.

The side cover 90 may be disposed in the gap G formed between the plurality of display modules 30A to 30P together with the first region 71 of the front cover 70 in the case of arraying the plurality of display modules 30A to 30P.

Accordingly, the side cover 90 may absorb light incident on the gap G to minimize/reduce reflection of the light incident on the gap G out of the gap G. Therefore, visibility of a seam formed by the gap G formed between the plurality of display modules 30A to 30P may be reduced.

The first display module 30A and the second display module 30B will be described as examples. A side cover 90A of the first display module 30A and a side cover 90B of the second display module 30B may be disposed in the gap G formed between the first display module 30A and the second display module 30B together with the first region 71A of the front cover 70A of the first display module 30A and the first region 71B of the front cover 70B of the second display module 30B).

In the gap G, a side end 91A of the side cover 90A of the first display module 30A and a side end 91B of the side cover 90B of the second display module 30B adjacent to the side end 91A of the side cover 90A of the first display module 30A may be disposed.

The side end 91A of the side cover 90A of the first display module 30A and the side end 91B of the side cover 90B of the second display module 30B adjacent to the side end 91A of the side cover 90A of the first display module 30A may be disposed to face each other.

A side end 75A of the front cover 70A of the first display module 30A and a side end 75B of the front cover 70B of the second display module 30B adjacent to the side end 75A of the front cover 70A of the first display module 30A may be disposed to face each other.

The side end 91A of the side cover 90A of the first display module 30A and the side end 91B of the side cover 90B of the second display module 30B adjacent to the side end 91A of the side cover 90A of the first display module 30A and the side end 75A of the front cover 70A of the first display module 30A and the side end 75B of the front cover 70B of the second display module 30B the side end 75A of the front cover 70A of the first display module 30A may be aligned parallel to each other.

In the gap G formed between the first display module 30A and the second display module 30B, the first region 71A of the front cover 70A of the first display module 30A and the first region 71B of the front cover 70B of the second display module 30B, and the side cover 90A of the first display module 30A and the side cover 90B of the second display module 30B may be disposed side by side in the third direction (Z).

A length of each of the side cover 90A of the first display module 30A and the side cover 90B of the second display module 30B extending in the third direction (Z) may be about a half or less of that of the gap G, formed between the first display module 30A and the second display module 30B, to correspond to the length of the first region 71A of the front cover 70A of the first display module 30A and the first region 71B of the front cover 70B of the second display module 30B.

The first region 71A of the front cover 70A of the first display module 30A and the first region 71B of the front cover 70B of the second display module 30B may be disposed on the gap G between the first display module 30A and the second display module 30B, and the side cover 90A of the first display module 30A and the side cover 90B of the second display module 30B may be disposed behind the first region 71A of the front cover 70A of the first display module 30A and the first region 71B of the front cover 70B of the second display module 30B in the first direction (X), respectively .

As described above, light incident on the display panel 20 may be diffusely reflected out of the display panel 20 or partially absorbed while passing through the first region 71A of the front cover 70A of the first display module 30A and the first region 71B of the front cover 70B of the second display module 30B, so that an amount of light reaching the gap G is reduced.

Although light partially arrives at the gap G, the light incident on the gap G is absorbed by the side cover 90A of the first display module 30A and the side cover 90B of the second display module 30B disposed in the gap G, so that visibility of boundaries between the first display module 30A and the second display module 30B may be reduced.

For example, by reducing the amount of light introduced into the gap G formed between the plurality of display modules 30A to 30P, and additionally absorbing light arriving at the gap G, the screen integrity of the display panel 20 may be improved.

Light, which is reflected by the side cover 90A of the first display module 30A and the side cover 90B of the second display module 30B and traveling toward the display panel 20 without being absorbed by the side cover 90A of the first display module 30A and the side cover 90B of the second display module 30B, may be diffusely reflected out of the display panel 20 or partially absorbed by the first region 71A of the front cover 70A of the first display module 30A and the first region 71B of the front cover 70B of the second display module 30B, while passing through the first region 71A of the front cover 70A of the first display module 30A and the first region 71B of the front cover 70B of the second display module 30B, and thus an amount of light transmitted to the outside may be reduced. Therefore, visibility of boundaries between the first display module 30A and the second display module 30B by the gap G may be reduced.

For example, as described above, the front cover 70 diffusely reflects, absorbs, circularly polarizes, or converts reflection direction of a part of light incident on the display module 20, and thus the amount of light arriving at the 40 is reduced.

For example, the front cover 70 may be formed of a transparent material allowing transmission of light without deformation of light. In this regard, visibility of boundaries between the plurality of display modules 30A to 30P in the gap may be reduced by the side cover 90 disposed between the plurality of display modules 30A to 30P.

The front cover 70 may be formed of a non-conductive material through which charges cannot pass.

The side cover 90 may be formed of a non-conductive material through which charges cannot pass.

Because the front cover 70 and the side cover 90 are formed of non-conductive materials, most of currents applied to the front cover 70 or the side cover 90 cannot pass through the front cover 70 and the side cover 90 but flow on the front cover 70 and the side cover 90.

The metal plate 60, formed of a material with a large electrostatic capacity, may serve as a grounding element. Accordingly, in the case where a currents is applied to the metal plate 60, a potential of the metal plate 60 may be maintained as a constant potential, so that the current flowing into the metal plate 60 is absorbed by the metal plate 60 and the current does not flow into the substrate 40 through the metal plate 60.

In addition, because the entire side wiring 46 of the substrate 40 is covered with the side cover 90 and accordingly the side wiring 46 is sealed not to be exposed to the outside, the current may not flow into the side wiring 46 by the side cover 90 even when electrostatic discharge occurs at the side surface 45 of the substrate 40.

For example, because the side end 47S of the anisotropic conductive layer 47 is disposed between the side end 91 of the side cover 90 and the side end 75 of the front cover 70, a part of the anisotropic conductive layer 47 may be exposed to the outside. For example, the anisotropic conductive layer 47 may be separated from the front cover 70 or the substrate 40 by a defect occurring during a manufacturing process of the display module 30, and the anisotropic conductive layer 47 may be separated from the side cover 90 during coating and curing processes.

In this case, a current may flow into the display modules 30A to 30P through the anisotropic conductive layer 47, which is located adjacent to the electric components and has low hardness and low resistance to electricity, by electrostatic discharge, and a problem of damage to electric components, such as side wiring mounted on the substrate 40, may occur due to the current introduced thereinto.

The display modules 30A to 30P may include the front cover 70 and the side cover 90 each independently formed of an non-conductive material to prevent/block a current generated by electrostatic discharge from flowing into components mounted on the substrate 40 and sealing the substrate 40, and the front cover 70 and the side cover 90 may be provided to easily guide the current generated by the electrostatic discharge to the metal plate 60, as a grounding element.

However, because the current may flow into the anisotropic conductive layer 47 disposed between the front cover 70 and the side cover 90, a side end member 100 covering the anisotropic conductive layer 47 from the outside of the display apparatus 1 may be included to prevent/reduce the current flow.

For example, one end 101 of the side end member 100 may be provided to extend downwards from the front end 79 of the front cover 70 in the first direction (X). The other end 102 of the side end member 100 may be located from the one end 101 to pass the anisotropic conductive layer 47 in the first direction (X).

For example, the other end 102 of the side end member 100 may be provided to extend to at least a portion of the side surface 65 of the metal plate 60 in the first direction (X) from the one end 101.

For example, the other end 102 of the side end member 100 may be provided to extend to at least a portion of the side cover 90 in the first direction (X) from the one end 101.

For example, the side end member 100 may be provided to seal the side end 75 of the front cover 70 to prevent/reduce the side end 75 of the front cover 70 from being exposed to the outside.

For example, the side end member 100 may seal the side end 47S of the anisotropic conductive layer 47 to prevent/reduce the side end 47S of the anisotropic conductive layer 47 from being exposed to the outside.

For example, the side end member 100 may seal the side end 91 of the side cover 90 to prevent/reduce the side end 91 of the side cover 90 from being exposed to the outside.

For example, the side end member 100 may seal the outer end between the front cover 70 and the anisotropic conductive layer 47 to prevent/reduce a contact surface between the front cover 70 and the anisotropic conductive layer 47 from being exposed to the outside.

For example, the side end member 100 may seal the outer end between the front cover 70 and the anisotropic conductive layer 47 to prevent/reduce a contact surface between the front cover 70 and the anisotropic conductive layer 47 from being exposed to the outside .

For example, the side end member 100 may seal the outer end between the side cover 90 and the anisotropic conductive layer 47 to prevent/reduce a contact surface between the side cover 90 and the anisotropic conductive layer 47 from being exposed to the outside.

For example, the side end member 100 may seal the outer end between the side cover 90 and the anisotropic conductive layer 47 to prevent/reduce a contact portion between the side cover 90 and the metal plate 60 from being exposed to the outside.

For example, the side end member 100 may seal the side end 91 of the side cover 90 to prevent/reduce the side end 91 of the side cover 90 from being exposed to the outside.

For example, the side end member 100 may cover the side end 75 of the front cover 70 to prevent/reduce the side end 75 of the front cover 70 from being exposed to the outside.

For example, the side end member 100 may cover the side end 47S of the anisotropic conductive layer 47 to prevent/reduce the side end 47S of the anisotropic conductive layer 47 from being exposed to the outside.

For example, the side end member 100 may cover the side end 91 of the side cover 90 to prevent/reduce the side end 91 of the side cover 90 from being exposed to the outside.

For example, the side end member 100 may cover the outer end between the front cover 70 and the anisotropic conductive layer 47 to prevent/reduce a contact surface between the front cover 70 and the anisotropic conductive layer 47 from being exposed to the outside.

For example, the side end member 100 may cover the outer end between the front cover 70 and the anisotropic conductive layer 47 to prevent/reduce a contact surface between the front cover 70 and the anisotropic conductive layer 47 from being exposed to the outside.

For example, the side end member 100 may cover the outer end between the side cover 90 and the anisotropic conductive layer 47 to prevent/reduce a contact surface between the side cover 90 and the anisotropic conductive layer 47 from being exposed to the outside.

For example, the side end member 100 may cover the outer end between the side cover 90 and the anisotropic conductive layer 47 to prevent/reduce a contact portion between the side cover 90 and the metal plate 60 from being exposed to the outside.

For example, the side end member 100 may be provided to seal the entire side surface 45 of the substrate 40.

For example, the side end member 100 may seal a contact surface between the front cover 70 and the anisotropic conductive layer 47 from the outside.

For example, the side end member 100 may seal a contact surface between the side cover 90 and the anisotropic conductive layer 47 from the outside.

For example, the side end member 100 may seal a contact portion between the side cover 90 and the metal plate 60 from the outside.

For example, the side end member 100 may seal the side cover 90 from the outside.

For example, the side end member 100 may seal all of the contact surface between the front cover 70 and the anisotropic conductive layer 47, the contact surface between the side cover 90 and the anisotropic conductive layer 47, the contact portion between the side cover 90 and the metal plate 60, and the side cover 90 from the outside.

Based on the display surface of the display modules 30A to 30P, the side end member 100 may be arranged at the farthest side end of the display modules 30A to 30P. The display surface of the display modules 30A to 30P is a screen where an image is displayed by the plurality of inorganic light-emitting devices 50 in the display modules 30A to 30P, and the side end member 100 that is a farthest side end may be defined as the side end 75 of the front cover 70.

For example, the side end member 100 may be formed of a non-conductive material.

For example, the side end member 100 may be formed on at least a part of an adhesive portion of the side end 75 of the front cover and the side end 47S of the anisotropic conductive layer 47, and an adhesive portion of the side end 91 of the side cover 90 and the side surface 65 of the metal plate 60 by coating.

For example, the side end member 100 be formed on at least a part of an adhesive portion of the side end 75 of the front cover 70 and the side end 47S of the anisotropic conductive layer 47, and an adhesive portion of the side end 91 of the side cover 90 and the side surface 65 of the metal plate 60 by transferring.

For example, the side end member 100 may include a polyester material.

For example, the side end member 100 may be formed of a material having a black-toned color.

For example, because the side end 47S of the anisotropic conductive layer 47 is not exposed to the outside by the side end member 100, the current generated by electrostatic discharge does not flow into the anisotropic conductive layer 47, but may be guided to the metal plate 60 along the side end member 100.

For example, because the contact surface between the front cover 70 and the anisotropic conductive layer 47 is not exposed to the outside by the side end member 100, the current generated by electrostatic discharge does not flow into the contact surface between the front cover 70 and the anisotropic conductive layer 47, but may be guided to the metal plate 60 along the side end member 100.

As described above, because the side end member 100 seals all of the contact surface between the front cover 70 and the anisotropic conductive layer 47, the contact surface between the side cover 90 and the anisotropic conductive layer 47, the contact portion between the side cover 90 and the metal plate 60, and the side cover 90, the current generated by electrostatic discharge does not flow into the contact surface between the front cover 70 and the anisotropic conductive layer 47, the contact surface between the side cover 90 and the anisotropic conductive layer 47, and the contact portion between the side cover 90 and the metal plate 60, but flows to the metal plate 60 along the side end member 100, thereby improving ESD performance.

For example, the side end member 100 may be disposed the farthest side ends of the first display module 30A and the second display module 30B, respectively. A side end cover 100A of the first display module 30A and a side end cover 100B of the second display module 30B may be disposed side by side. The side end cover 100A of the first display module 30A and the side end cover 100B of the second display module 30B may be disposed in contact with each other.

Accordingly, separation d between the farthest side ends of the first display module 30A and the second display module 30B may be identical to a thickness of the side end cover 100A of the first display module 30A and the side end cover 100B of the second display module 30B.

In the absence of the side end member 100, a grounding member connected to the metal plate 60 may further be disposed on the farthest side end of the display modules 30A to 30P, in order to prevent/reduce the current generated by electrostatic discharge form flowing into the anisotropic conductive layer 47 or the contact surface between the anisotropic conductive layer 47 and the front cover 70. The grounding member is generally formed of a metallic material to have a predetermined thickness or more, and separation between the farthest side ends of the display modules 30A to 30P may be enlarged by the grounding member, and accordingly, recognition of seams between the display modules 30A to 30P may be increased.

However, because ESD resistance is improved by the side end member 100 even without the grounding member, the grounding member is not located on the farthest side end of the display modules 30A to 30P, and accordingly the separation d between the farthest side ends of the display modules 30A to 30P may be minimized/reduced, thereby reducing recognition of seams.

The side end member 100 may be formed of a material having a black-toned color. Because the side end member 100 is located in the gap G between the display modules 30A to 30P, the side end member 100 may reduce visibility of seams between the display modules 30A to 30P by absorbing light emitted to the gap G between the display modules 30A to 30P.

The side end member 100 may be provided to cover the side end 75 of the front cover 70. In addition, as described above, because the side end member 100 has a black-toned color, a light leakage phenomenon in which a part of light emitted by the plurality of inorganic light-emitting devices 50 infiltrates into the side end 75 of the front cover 70 may be prevented/reduced.

For example, the side end member 100 covers the entire side end 75 of the front cover 70 by disposing one end 101 of the side end member 100 at a position corresponding to the front end 79 of the front cover 70, and accordingly light penetrating the side end 75 from the inside of the front cover 70 is absorbed by the side end member 100, so that the light leakage phenomenon through the side surface may be prevented/reduced in the display module 30.

For example, the side end member 100 may be made of a moisture-proof material. By the side end member 100, entering of a solution such as moisture through an adhesive portion of the side end 47S of the anisotropic conductive layer 47 and the side end 75 of the front cover 70 or an adhesive portion of the side end 47S of the anisotropic conductive layer 47 and the side end 91 of the side cover 90 may be prevented/reduced. As described above, because the side cover 90 is provided to seal edges of the display modules 30A to 30P, all of the side wiring 46, the first end portion 46b of the side wiring 46 and the side surface 45, and the rear pad 43e connected to the side wiring 46 may be covered thereby, so that infiltration of a solution such as moisture from the outside may be prevented/reduced. Because the side end member 100 additionally seals the side cover 90, infiltration of a solution such as moisture into the side end member 100 may be prevented/reduced.

For example, the side end member 100 may be made of a water repellent material. The solution such as moisture cannot infiltrate into the side end member 100, but may flow on the side end member 100.

For example, the side end member 100 may be replaced with a water-proof material, thereby preventing/reducing a solution from being absorbed into the side end member 100 and flowing into the side wiring 46, the rear pad 43e, or the side surface 45.

As described above, due to the coating member 46e surrounding the side wiring 46, entering of an external solution through the side wiring 46 may be prevented/reduced even when the side wiring 46 is exposed to the outside. However, in the case where the external solution is an alkaline solution such as a cleaning solution, the coating member 46e may be removed by the alkaline solution causing damage to the side wiring 46. Because the side end member 100 seals all of the contact surface between the front cover 70 and the anisotropic conductive layer 47, the contact surface between the side cover 90 and the anisotropic conductive layer 47, and the contact portion between the side cover 90 and the metal plate 60, as well as the side cover 90 covering the entire side wiring 46, damage to the side wiring 46 and electric components mounted on the substrate 40 caused by the external solution may be prevented/reduced.

Hereinafter, a method of manufacturing the display module 30 according to an embodiment of the present disclosure will be briefly described.

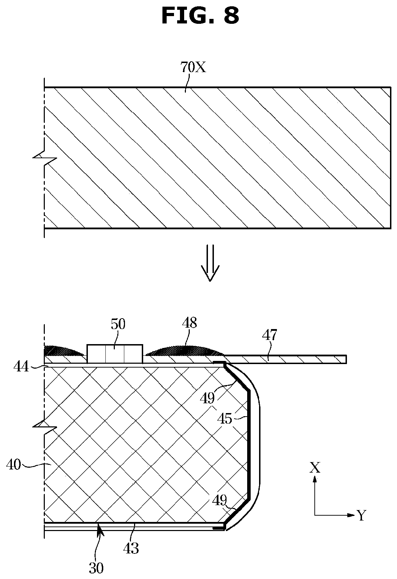

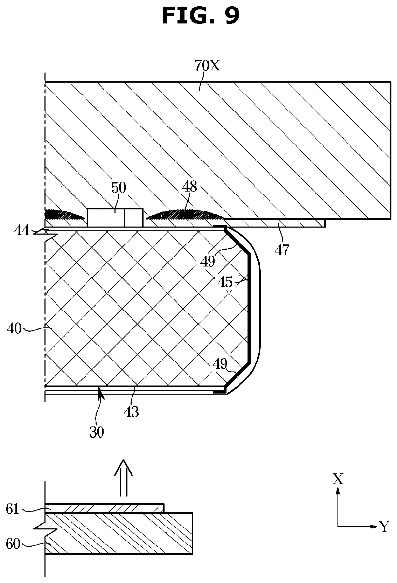

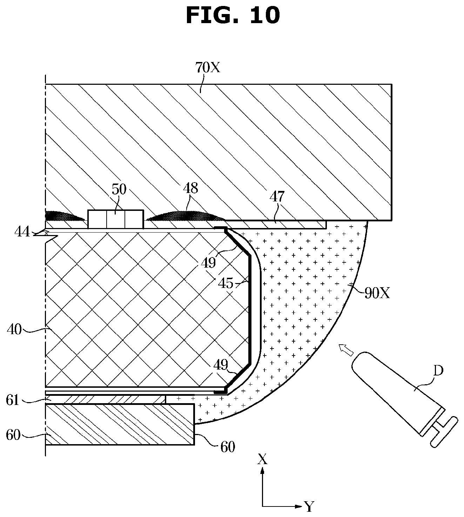

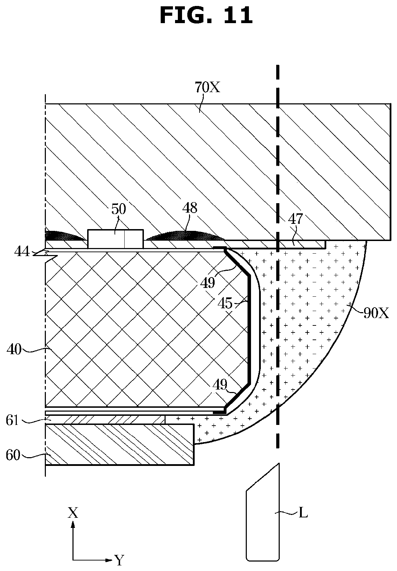

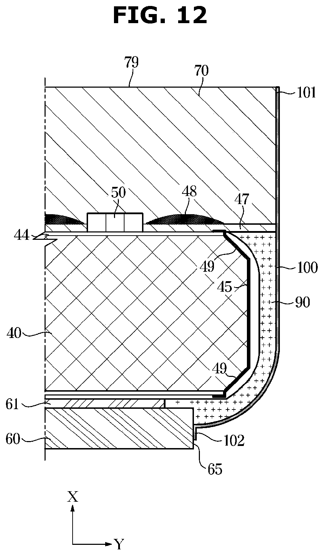

FIG. 8 is a diagram illustrating an example process of manufacturing a display apparatus according to various embodiments. FIG. 9 is a diagram illustrating an example process of manufacturing the display apparatus after FIG. 8 according to various embodiments. FIG. 10 is a diagram illustrating an example process of manufacturing the display apparatus after FIG. 9 according to various embodiments. FIG. 11 is a diagram illustrating an example process of manufacturing the display apparatus after FIG. 10 according to various embodiments. FIG. 12 is a diagram illustrating an example process of manufacturing the display apparatus after FIG. 11 according to various embodiments.

As shown in FIG. 8, a substrate 40 to which an anisotropic conductive film 47X, disposed on the TFT layer 44 formed on the mounting surface 41 of the substrate 40, is adhered is prepared.

The anisotropic conductive film 47X refers to a state before being cut into the anisotropic conductive layer 47 of the display module 30.

An area of the anisotropic conductive film 47X may be greater than an area of the substrate 40.

In the case where the side end 47S of the anisotropic conductive layer 47 is located at an area outside the side cover 90, the side end 47S of the anisotropic conductive layer 47 may be disposed in the gap G between the plurality of display modules 30A to 30P. Accordingly, the side end 47S of the anisotropic conductive layer 47 may be recognized as a seam between the plurality of display modules 30A to 30P, thereby deteriorating screen integrity of the display panel 20.

In addition, a current generated by electrostatic discharge may flow into the display module through the side end 47S of the anisotropic conductive layer 47, so that a problem of damage to the electric components mounted in the display module may occur.

For example, in the case of electrostatic discharge occurring around the display module 30, the side end 47S of the anisotropic conductive layer 47 may be exposed to the outside, and high-voltage electricity may be introduced into the display module 30 through the side end 47S of the anisotropic conductive layer 47, thereby causing damage to the display module 30.

To avoid this, as described above, although the anisotropic conductive film 47X will be described below, a front cover 70X and a side cover 90X may be simultaneously cut, and then sealed by the side end member 100.

As the anisotropic conductive film 47X is cut simultaneously with the front cover 70X and the side cover 90X, the side end 47S of the anisotropic conductive layer 47 may not be located at an area outside the side cover 90, and after the cutting process, the side end member 100 seals the side end 47S of the anisotropic conductive layer 47, thereby improving ESD performance.

A front cover 70X is adhered to the mounting surface 41 of the prepared display module 30. In this regard, the front cover 70X refers to a front cover 70X before being cut. The front cover 70X may be provided to cover the entire area of the mounting surface 41.

For example, the front cover 70X may be formed by a compression molding process on the mounting surface 41. For example, the front cover 70X may be bonded onto the mounting surface 41 by lamination.

As shown in FIG. 9, the metal plate 60 may be adhered to the rear surface 43 of the substrate 40.

Because the rear adhesive tape 61 is disposed on the upper surface of the metal plate 60 in the first direction (X), the rear adhesive tape 61 may adhere the substrate 40 to the metal plate 60 by compressing the rear adhesive tape 61 and the rear surface 43 of the substrate 40.

However, the disclosure is not limited thereto, and the rear adhesive tape 61 may be disposed on the rear surface 43 of the substrate 40 and the metal plate 60 may be compressed onto the rear adhesive tape 61 disposed on the rear surface 43.

As shown in FIG. 10, the side cover 90X is dispensed from the rear surface of the front cover 70X to the side surface 45 of the substrate 40 and at least a portion of the side surface 65 of the metal plate 60 in the first direction (X). In this regard, the side cover 90X refers to a side cover 90X before being cut with the front cover 70X.

The side cover 90X may be applied in a predetermined amount by a dispenser (D). The applied side cover 90X may be cured by a subsequent process. The side cover 90X may be formed of, for example, a non-conductive black resin.

The side cover 90X may be applied to cover all of the rear surface of the front cover 70X, the anisotropic conductive film 47X located on the rear surface of the front cover 70X, the side surface 45 and the chamfer 49 of the substrate 40, a contact portion between the rear surface 43 of the substrate 40 and the metal plate 60, and at least a portion of the side surface 65 of the metal plate 60.

The dispensing process of the side cover 90X may be performed at all of the 4 edges E of the substrate 40. Accordingly, the side cover 90X may be dispensed to cover all side surfaces 45 of the substrate 40. Also, the entire area 47X of the anisotropic conductive layer 47 disposed at an area outside the mounting surface 41 may be covered with the side cover 90X.

While being cured, the side cover 90X may be bonded to all of the rear surface of the front cover 70X, the anisotropic conductive film 47X located on the rear surface of the front cover 70X, the side surface 45 and the chamfer 49 of the substrate 40, a contact portion between the rear surface 43 of the substrate 40 and the metal plate 60, and at least a portion of the side surface 65 of the metal plate 60.

In the case of including a photosensitive material, the side cover 90X may be turned to a dark color by irradiation of ultraviolet (UV) light as a follow-up process. However, in the case where the side cover 90X does not include a photosensitive material, but may be formed of a translucent or opaque material, these processes are not necessary.

As shown in FIG. 11, the front cover 70X, the anisotropic conductive film 47X, and the side cover 90X are cut in the first direction (X), such that at least a portion of the front cover 70X extends to an area outside the substrate 40 in the second direction (Y) and third direction (Z) both perpendicular to the first direction (X) where the mounting surface 41 faces.

As a cutting process, laser (L) cutting may be performed. Accordingly, the front cover 70X, the anisotropic conductive film 47X, and the side cover 90X may be simultaneously cut.

Because the anisotropic conductive film 47X is cut simultaneously with the front cover 70X and the side cover 90X, the side end 47S of the anisotropic conductive layer 47 may not be located at an area outside the side cover 90.

By the cutting process, the front cover 70X and the side cover 90X may be cut such that the front cover 70X including the first region 71 not only in the second direction (Y) but also the third direction (Z) respectively perpendicular to the first direction (X) and the second direction (Y), and the side cover 90X is disposed in the second direction (Y) and the third direction (Z).

For example, the cutting process may be performed at all of the 4 edges E of the substrate 40.

As shown in FIG. 12, the side end member 100 may be applied to the side end of the substrate 40.

The side end member 100 may be coated such that one end 101 of the side end member 100 is located at a position corresponding to the front end 79 of the front cover 70, and the other end 102 of the side end member 100 may be located at at least one portion of the side surface 65 of the metal plate 60.

As described above, the display module 30 includes a substrate 40 including a mounting surface 41 on which a TFT layer 44 is formed, a side surface 45, and a rear surface 43 disposed on the opposite side of the mounting surface 41, a plurality of inorganic light-emitting devices 50 mounted on the mounting surface 41, an anisotropic conductive layer 47 electrically connecting the TFT layer 44 with the plurality of inorganic light-emitting devices 50 and disposed on the upper surface of the TFT layer 44, a front cover 70 covering the front surface of the anisotropic conductive layer 47, a side cover 90 surrounding the side surface 45, and a side end member 100 sealing the outer end of the side cover 90.

The side end 75 of the front cover 70 may extend to an area outside the mounting surface 41. Accordingly, the front cover 70 may easily cover the entire mounting surface 41.

The side end 47S of the anisotropic conductive layer 47 extends to an area outside the mounting surface 41 to be located at a position corresponding to the side end 75 of the front cover 70.

The side cover 90 may be provided to be in contact with the lower surface of the anisotropic conductive layer 47 corresponding to the area outside the mounting surface 41. Accordingly, the side cover 90 may easily seal the side end of the substrate 40 by covering all of the side surface 45 of the substrate 40 and an adhesive portion of the side surface 45 and the anisotropic conductive layer 47.

The side end member 100 is provided to seal a space between the side end of the front cover 70 and the side end of the anisotropic conductive layer 47. Therefore, a light leakage phenomenon in which light emitted to the side end through the front cover 70 leaks may be prevented/reduced, and the inflow of the current caused by electrostatic discharge through the side end of the front cover 70 and the side end of the anisotropic conductive layer 47 may be prevented/reduced.

The front end of the side end member 100 is located at a position corresponding to the front end of the front cover 70 in a direction where the mounting surface 41 faces. Therefore, the side end member 100 may easily prevent/reduce the light leakage phenomenon that may occur in the front cover 70.

As described above, the display module 30 further includes a metal plate 60 adhered to the rear surface 43. The side end member 100 is provided to seal from a position corresponding to the front end of the front cover 70 to at least a portion of the side surface of the metal plate 60. Therefore, the side end member 100 may prevent/reduce separation between the metal plate 60 and the front cover 70 from being exposed to the outside by sealing the separation that may be formed between the front cover 70 and the metal plate 60.

The side cover 90 is provided from the lower surface of the anisotropic conductive layer 47 corresponding to the area outside the mounting surface 41 to at least a portion of the side surface of the metal plate 60. Accordingly, the side cover 90 may also seal separation that may occur between the substrate 40 and the metal plate 60 to prevent/reduce the separation between the metal plate 60 and the substrate 40 from being exposed to the outside.

The side end member 100 may be made of a moisture-proof material preventing/reducing infiltration of moisture. Accordingly, infiltration of moisture from the side end of the substrate 40 may be prevented/reduced.

The side end member 100 is made of a water repellent material. Accordingly, infiltration of moisture from the side end of the substrate 40 may be prevented/reduced.

The side end member 100 has a black-toned color. Therefore, the recognition of seams between the display modules 30 may be reduced.

The side cover 90 has a black-toned color. Therefore, the recognition of seams between the display modules 30 may be reduced.

The side end member 100 may be made of a moisture-proof material preventing/reducing infiltration of moisture. Accordingly, infiltration of moisture from the side end of the substrate 40 may be prevented/reduced.

The side cover 90 is made of a water repellent material. Accordingly, infiltration of moisture from the side end of the substrate 40 may be prevented/reduced.

Although various example embodiments of the present disclosure have been provided for illustrative purposes, the scope of the present disclosure is not limited thereto. The examples illustrated in the disclosure may be modified and altered by those skilled in the art without departing from the principles and spirit of the present disclosure, including the appended claims and their equivalents. It will also be understood that any of the embodiment(s) described herein may be used in conjunction with any other embodiment(s) described herein.

## Claims

1. A display module comprising:
a substrate including a mounting surface on which a thin film transistor (TFT) layer is formed, a side surface, and a rear surface disposed on an opposite side of the mounting surface;
a plurality of inorganic light-emitting devices mounted on the mounting surface;
an anisotropic conductive layer electrically connecting the TFT layer to the plurality of inorganic light-emitting devices and disposed on an upper surface of the TFT layer;
a front cover configured to cover a front surface of the anisotropic conductive layer;
a side cover configured to surround the side surface; and
a side end member configured to seal an outer end of the side cover,
wherein a side end of the front cover extends to an area outside the mounting surface,
a side end of the anisotropic conductive layer extends to the area outside the mounting surface to be disposed at a position corresponding to the side end of the front cover,
the side cover is configured to be in contact with a lower surface of the anisotropic conductive layer corresponding to the area outside the mounting surface, and
the side end member is configured to seal a portion of the side end of the front cover and the side end of the anisotropic conductive layer.

2. The display module according to claim 1, wherein a front end of the side end member is disposed at a position corresponding to a front end of the front cover in a direction where the mounting surface faces.

3. The display module according to claim 1, further comprising a metal plate bonded to the rear surface,
wherein the side end member extends to at least a portion of a side surface of the metal plate from a position corresponding to the front end of the front cover.

4. The display module according to claim 3, wherein the side cover extends from the lower surface of the anisotropic conductive layer corresponding to the area outside the mounting surface to at least a portion of the side surface of the metal plate.

5. The display module according to claim 1, wherein the side end member is formed of a moisture-proof material that prevents infiltration of moisture.

6. The display module according to claim 1, wherein the side end member is formed of a water repellent material.

7. The display module according to claim 1, wherein the side end member has a black-toned color.

8. The display module according to claim 1, wherein the side cover has a black-toned color.

9. The display module according to claim 1, wherein the side end member is formed of a moisture-proof material that prevents infiltration of moisture.

10. The display module according to claim 1, wherein the side cover is formed of a water repellent material.

11. The display module according to claim 3, wherein the side end member seals a portion between the front cover and the anisotropic conductive layer, a portion between the anisotropic conductive layer and the side cover, and a portion between the metal plate and the side cover.

12. A display apparatus comprising an array of a plurality of display modules horizontally arranged in a M*N matrix, and a frame supporting the plurality of display modules,
wherein each of the plurality of display modules comprises:
a substrate including a mounting surface on which a thin film transistor (TFT) layer is formed, a side surface, and a rear surface disposed on an opposite side of the mounting surface;
a plurality of inorganic light-emitting devices mounted on the mounting surface;
an anisotropic conductive layer electrically connecting the TFT layer to the plurality of inorganic light-emitting devices and disposed on an upper surface of the TFT layer;
a front cover configured to cover the front surface of the anisotropic conductive layer;
a side cover configured to surround the side surface; and
a side end member configured to seal an outer end of the side cover,
wherein a side end of the front cover extends to an area outside the mounting surface,
a side end of the anisotropic conductive layer extends to the area outside the mounting surface to be disposed at a position corresponding to the side end of the front cover,
the side cover is configured to be in contact with a lower surface of the anisotropic conductive layer corresponding to the area outside the mounting surface, and
the side end member is configured to seal a portion of the side end of the front cover and the side end of the anisotropic conductive layer.

13. The display apparatus according to claim 12, wherein a front end of the side end member is disposed at a position corresponding to a front end of the front cover in a direction where the mounting surface faces.

14. The display apparatus according to claim 13, further comprising a metal plate bonded to the rear surface,
wherein the side end member extends to at least a portion of a side surface of the metal plate from a position corresponding to the front end of the front cover.

15. The display apparatus according to claim 14, wherein the side cover extends from the lower surface of the anisotropic conductive layer corresponding to the area outside the mounting surface to at least a portion of the side surface of the metal plate.
